# FASCICULE DE BREVET EUROPEEN

(11) **EP 3 711 096 B1**
(45) Date de publication et mention de la délivrance du brevet: **27.03.2024**
(21) Numéro de dépôt: 18796993.6
(22) Date de dépôt: 13.11.2018
(51) Int. Cl.: H01L 27/146, H01L 27/15

(54) **SYSTEME OPTIQUE/ELECTRONIQUE HYBRIDE AMELIORE**
VERBESSERTES HYBRIDES OPTISCHES/ELEKTRONISCHES SYSTEM
IMPROVED HYBRID OPTICAL/ELECTRONIC SYSTEM

(30) Priorité: 14.11.2017 FR 1701175
(43) Date de publication de la demande: 23.09.2020
(73) Titulaire: THALES, 92190 Meudon (FR); Commissariat à l'Energie Atomique et aux Energies Alternatives, 75015 Paris (FR)
(72) Inventeur: REVERCHON, Jean-Luc, 91767 Palaiseau Cedex (FR); LE GOFF, Florian, 91767 Palaiseau Cedex (FR)
(74) Mandataire: Atout PI Laplace
(86) Numéro de dépôt international: PCT/EP2018/081093
(87) Numéro de publication internationale: WO 2019/096794

(56) Documents cités:
- WO-A1-2013/079603
- WO-A1-2017/037527
- US-A1- 2016 307 946
- US-A1- 2017 221 951

## Description

### DOMAINE DE L'INVENTION

L'invention concerne les systèmes hybrides, c'est à dire constitués de deux parties distinctes assemblées par une couche d'assemblage, chaque partie étant réalisée dans un matériau différent. Ces systèmes peuvent être optique, électronique ou optoélectronique en fonction des caractéristiques des parties assemblées. L'invention concerne particulièrement l'amélioration des performances de la couche d'assemblage d'un système hybride.

### ETAT DE LA TECHNIQUE

Les systèmes hybrides permettent d'associer deux fonctionnalités réalisées dans des matériaux différents. Il s'agit par exemple :
- d'un détecteur, dans lequel la partie sensible est associée à un circuit de lecture permettant de récolter et traiter le signal à détecter,
- d'un afficheur, par exemple de type électroluminescent, dans lequel la partie émettrice est associée avec un circuit de génération de signaux électriques adaptés à l'émission,
- d'un circuit photonique, avec des émetteurs lasers associés à des couches de traitement des faisceaux émis (guidage, multiplexage/démultiplexage, amplification ...), la/les couches de traitement étant déposées sur un substrat silicium (« Photonic on Silicon »),
- d'un circuit électronique avec des transistors rapides ou de puissance associés à un système de contrôle.

Les deux premiers systèmes hybrides peuvent être qualifiés d'optoélectroniques, le troisième peut être purement optique ou optoélectronique, tandis que le quatrième est purement électronique. Le document US 2017/221951 A1 décrit un système optoélectronique hybride.

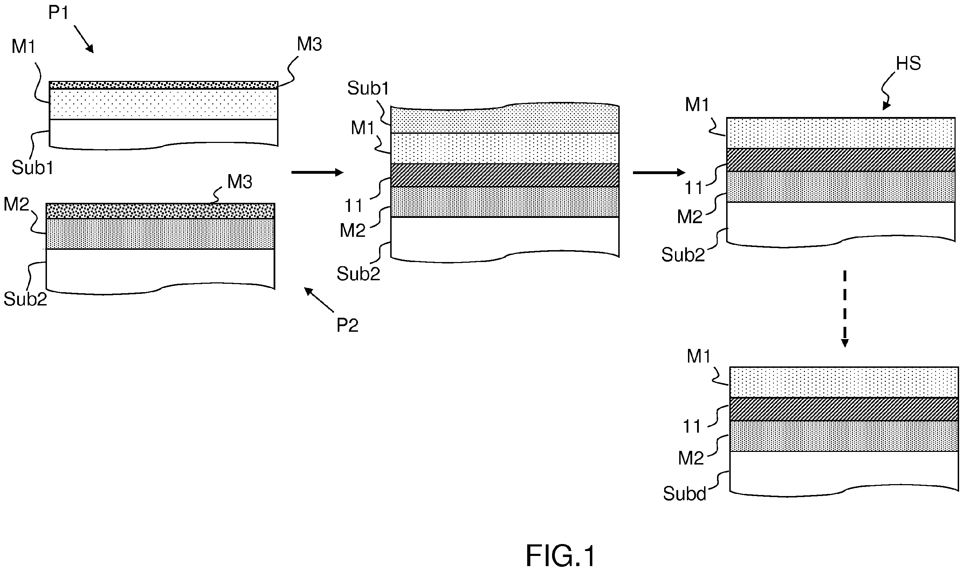

De manière générale, les systèmes hybrides HS sont réalisés tel que décrit figure 1.

Au départ on a une première partie P1 assurant une première fonctionnalité, par exemple la détection ou l'émission, réalisée dans un (ou plusieurs) premier matériau M1 sur un substrat Subi, et une deuxième partie P2 assurant une deuxième fonctionnalité, par exemple un circuit sur silicium permettant la lecture ou la génération de signaux électriques, réalisée dans un deuxième matériau M2 différent du premier matériau M1 et supportée par un substrat Sub2. Ces deux parties sont réalisées indépendamment. On dispose sur chacune d'elles une couche d'un matériau M3 qui va être utilisé pour effectuer l'assemblage. Ces deux parties sont de structure planaire, et présentent une « grande surface », c'est-à-dire typiquement 1 mm² ou plus. Puis les deux parties sont assemblées l'une avec l'autre par un procédé d'assemblage, le matériau M3 permettant de former la couche d'assemblage 11. Cette étape est également dénommée hybridation.

Une technique d'assemblage en plein développement est le collage. Elle constitue un progrès important pour la réalisation d'étapes technologiques dites « above IC », c'est-à-dire d'étapes réalisables directement sur la plaque du circuit formant l'une des parties, typiquement de type CMOS, et de manière collective sur l'ensemble des puces. Cette compatibilité avec les moyens de fabrication CMOS est adaptée à une baisse significative des coûts de production et à la possibilité d'atteindre des motifs technologiques de taille plus fine.

Un exemple de collage est le collage moléculaire. Cette méthode consiste à préparer spécifiquement la surface des deux parties avec comme M3 un dépôt d'un matériau diélectrique, typiquement de la silice, puis à effectuer des planarisations. On les met ensuite en contact mécaniquement, puis on réalise un recuit thermique (de l'ordre de 200°C). La couche finale d'assemblage 11, par exemple du SiO₂, présente une épaisseur fine, typiquement de quelques dizaines de nm à quelques µm.

On peut également utiliser de l'époxy sur une des parties puis procéder à l'assemblage.

Une fois l'assemblage réalisé, on procède généralement à l'élimination d'un des substrats. Dans certains cas, on enlève également le substrat restant, pour le remplacer par un substrat de destination Subd, moins cher et/ou présentant de meilleures propriétés mécaniques ou autres (faibles pertes diélectriques).

L'étape d'assemblage est une étape à haut risque, et les inventeurs ont mis en évidence certains effets négatifs induits par le collage sur des détecteurs hybrides.

Un but de la présente invention est de remédier aux inconvénients précités en proposant un système hybride présentant une qualité d'assemblage améliorée.

### DESCRIPTION DE L'INVENTION

La présente invention a pour objet un système optique et/ou électronique hybride comme défini dans la revendication 1.

Préférentiellement une profondeur d'un évidement est telle qu'un fond dudit évidement est disposé à une distance de la couche d'assemblage inférieure à 1µm.

Selon un mode de réalisation les évidements présentent la forme de trous ou de sillons.

Selon un mode de réalisation les évidements sont recouverts d'une couche métallique.

Préférentiellement le matériau de la structure planaire évidée présente un coefficient de dilatation thermique supérieur au coefficient de dilatation thermique de l'autre structure planaire.

Selon un mode de réalisation la structure planaire évidée présente une épaisseur inférieure à 20 µm.

Préférentiellement l'assemblage est réalisé par collage moléculaire. Préférentiellement une surface de l'au moins une zone active est supérieure ou égale à 1 mm².

Selon une première variante l'invention concerne un système optoélectronique de détection selon l'une des revendications précédentes comprenant une matrice de pixels,
dans lequel la première fonctionnalité est une photo-génération pixélisée de porteurs, la première structure comprenant une pluralité de couches dont une couche absorbante en matériau semi-conducteur II-VI ou III-V,
dans lequel la deuxième fonctionnalité est une lecture d'un signal électrique généré par un pixel, la deuxième structure comprenant un circuit de lecture comprenant une pluralité de contacts enterrés,
et dans lequel l'au moins une zone active comprend ladite matrice de pixels et l'au moins une zone neutre est disposée en périphérie de ladite matrice de pixels.

Préférentiellement la première structure comprend dans au moins une couche une pluralité de zones dopées configurées pour collecter des porteurs photogénérés par la couche absorbante, une zone dopée permettant de définir un pixel du système de détection, dans lequel le signal électrique est généré par un pixel à partir desdits porteurs photogénérés par la couche absorbante , une connexion électrique entre une zone dopée et un contact enterré du circuit de lecture étant réalisée via des trous d'interconnexion métallisés, et dans lequel la structure planaire évidée est celle qui est traversée par les trous d'interconnexions.

Selon un premier mode de réalisation la deuxième structure est disposée sur le substrat rigide, dans lequel les trous d'interconnexion traversent la première structure et le circuit de lecture jusqu'au contact, dans lequel chaque zone dopée s'étend de manière annulaire autour d'un trou d'interconnexion, la structure planaire évidée étant la première structure planaire.

Préférentiellement une profondeur d'un évidement est telle que ledit évidement n'atteint pas le circuit de lecture.

Préférentiellement les évidements sont réalisés dans la zone neutre disposée entre un contact commun et des plots de contact dudit système. Selon un mode de réalisation une première pluralité d'évidements sont interconnectés entre eux de manière à former un plot de test et une deuxième pluralité d'évidements sont reliés entre eux et audit contact commun de la matrice de pixels.

Selon un deuxième mode de réalisation la première structure planaire est disposée sur le substrat rigide, ledit substrat rigide étant transparent, chaque zone dopée (DZ) est réalisée dans une couche de contact (CL) disposée sous la couche absorbante (AL), la deuxième structure planaire (S2) est disposée sur un substrat aminci (Sub'), les trous d'interconnexion (IH) traversent le substrat aminci (Sub') et la deuxième structure planaire (S2), la structure planaire évidée étant la deuxième structure planaire, les évidements étant réalisés dans le substrat aminci Sub' et la deuxième structure planaire S2.

Selon une deuxième variante l'invention concerne un système optoélectronique d'affichage comprenant une matrice de pixels électroluminescents, dans lequel la première fonctionnalité est une émission pixélisée, la première structure planaire comprenant une pluralité de couches dont une couche électroluminescente, dans lequel la deuxième fonctionnalité est une génération de signaux électriques adaptés pour réaliser l'émission électroluminescente, la deuxième structure planaire comprenant un circuit d'adressage des pixels déposé sur un substrat en silicium, et dans lequel l'au moins une zone active comprend ladite matrice de pixels et l'au moins une zone neutre est disposée en périphérie de ladite matrice de pixels, la structure évidée correspondant à la première structure planaire.

Selon une troisième variante l'invention concerne un système électronique dans lequel la première structure planaire comprend une pluralité de transistors et la deuxième structure planaire comprend des circuits associés auxdits transistors, et dans lequel l'au moins une zone active comprend lesdits transistors et l'au moins une zone neutre est disposée en périphérie desdits transistors, la structure évidée correspondant à la première structure planaire.

Préférentiellement, pour la deuxième et troisième variante le système comprend en outre des via d'interconnexion CV dans la zone active.

Selon un autre aspect l'invention concerne un procédé de fabrication d'un système hybride optique et/ou électronique hybride comme défini dans la revendication 19.

D'autres caractéristiques, buts et avantages de la présente invention apparaîtront à la lecture de la description détaillée qui va suivre et en regard des dessins annexés donnés à titre d'exemples non limitatifs et sur lesquels :
La figure 1 déjà citée illustre un procédé de réalisation d'un système hybride selon l'état de la technique.
La figure 2 illustre un premier type de détecteur optique hybride présentant une matrice de photodiodes de type « loop hole ».
La figure 3 illustre le principe du procédé pour réaliser un détecteur de type « loop hole ». Les figures 3a à 3e schématisent les différentes étapes de ce procédé.
La figure 4 illustre un deuxième type de détecteur optique hybride, particulièrement adapté pour l'infra rouge, dénommé TSV.
La figure 5 illustre un système hybride « grande surface », présentant un ensemble de pixels Pix agencés selon une matrice.
La figure 6 illustre le décollement de la couche reportée de matériau III-V du circuit de lecture déposé sur un substrat.
La figure 7 est une photographie de la zone de collage d'un système hybride de type détecteur « loop hole » tel qu'illustré figure 2 après l'étape de diffusion du zinc à haute température.
La figure 8 illustre un système hybride selon l'invention en coupe
La figure 9 illustre un système hybride selon l'invention en vue de dessus du côté présentant les trous.
La figure 10 illustre un système hybride selon l'invention présentant des évidements en forme de sillon.
La figure 11 illustre une première variante d'un système optoélectronique de détection selon l'invention comprenant une matrice de pixels.
La figure 12 illustre une deuxième variante d'un système optoélectronique de détection selon l'invention comprenant une matrice de pixels.
La figure 13 illustre un système hybride de détection selon l'invention de type « loop hole ».
La figure 14 illustre un mode du système de détection de type « loop hole »selon l'invention.
La figure 15 illustre un mode particulier du système de détection de type « loop hole » selon l'invention.
La figure 16 illustre un système hybride de détection de type TSV selon la deuxième variante de l'invention.
La figure 17 illustre un système optoélectronique hybride d'affichage comprenant une matrice de pixels électroluminescents selon l'invention.
La figure 18 illustre un système électronique hybride de transistors de puissance et/ou rapides selon l'invention.
La figure 19 illustre un système optique ou optoélectronique comprenant des émetteurs laser.
La figure 20 illustre un procédé de fabrication d'un système hybride optique et/ou électronique hybride selon l'invention.
La figure 21 illustre une variante du procédé illustré figure 20
La figure 22 illustre une variante du procédé illustré figure 21 appliquée aux systèmes de détection.

### DESCRIPTION DETAILLEE DE L'INVENTION

Les inventeurs ont particulièrement étudié les détecteurs hybrides utilisant des via d'interconnexions pour mettre en relation les éléments de détection et le circuit de lecture. Cette étude a permis de mettre en évidence l'apparition de « bulles » et, suite à l'analyse de ce phénomène, de proposer une solution permettant de les supprimer.

Deux types de détecteurs hybrides à via d'interconnexions basés sur une technologie III-V sont décrits ci-dessous. Ils opèrent dans la gamme infrarouge et sont constitués par assemblage d'une matrice comprenant une pluralité de pixels élémentaires à base de photodiodes transformant un flux de photons incidents en porteurs photogénérés, et d'un circuit de lecture couramment dénommé ROIC pour « Read Out Integrated Circuit » en anglais pour collecter le signal électrique issu des pixels du détecteur.

Un premier type de détecteur comprend des trous d'interconnexion dénommés en anglais « via-hole » et des photodiodes de symétrie cylindrique autour de ces trous d'interconnexion. Cette photodiode est communément appelée « loop-hole ». On réalise ainsi un imageur infrarouge en couplant interconnexion 3D (circuit ROIC) et photodiode cylindrique.

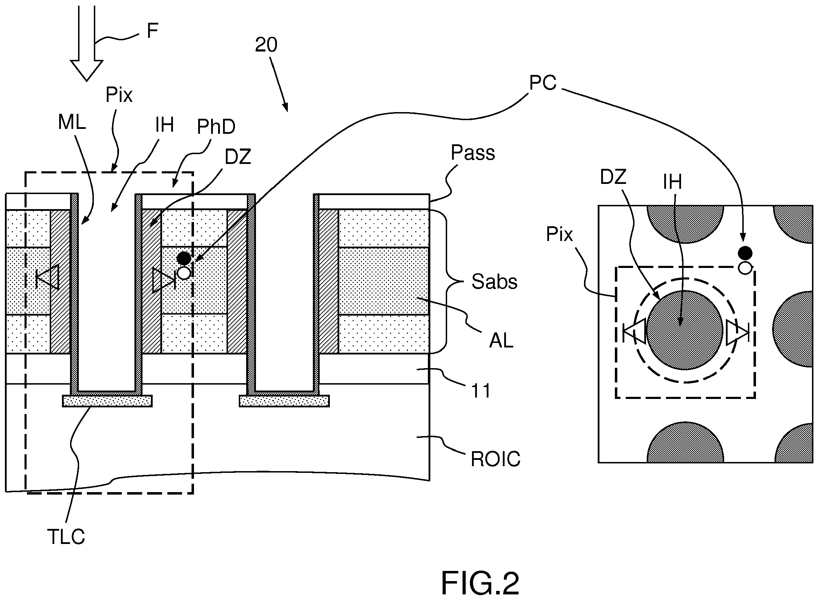

Un détecteur optique hybride 20 présentant une matrice de photodiodes de type « loop hole » adaptées pour une structure absorbante réalisée avec des matériaux III-V est illustré figure 2, la figure 2a correspondant à une coupe transversale et la figure 2b à une vue de dessus.

La matrice de photodétecteurs comprend une structure absorbante Sabs comprenant au moins une couche absorbante AL en matériau III-V ou II-VI, apte à générer des porteurs PC à partir d'un flux de photons incidents F. La structure Sabs est recouverte d'une couche de passivation Pass. Cette structure est assemblée au circuit ROIC par une couche d'assemblage 11, selon le procédé décrit ci-dessus.

Les contacts du circuit de lecture ROIC destinés à recevoir le signal électrique généré par chaque pixel Pix du détecteur sont des contacts TLC enterrés dénommés « Top Level Contacts » en anglais. Ils sont réalisés en fin de procédé de fabrication des circuits intégrés, et sont localisés proches de la surface du circuit.

Dans une matrice de type « loop hole » une diode cylindrique PhD est réalisée autour d'un trou d'interconnexion IH (pour « Interconnection Hole » en anglais), qui traverse la structure absorbante, la couche d'assemblage 11 et le circuit ROIC jusqu'au contact TLC. Les parois du trou IH sont recouvertes d'une couche de métallisation ML, réalisant la liaison électrique entre la diode PhD et le contact TLC.

La diode PhD est réalisée par dopage localisé d'une zone DZ proche du trou IH d'un type opposé au dopage initial de la couche absorbante AL. La photodiode de type p-n réalise la séparation et le transport des porteurs photo-générés vers la couche de métallisation ML et collecte les porteurs minoritaires (les trous lorsque la zone DZ est dopée p). Chaque zone dopée DZ qui s'étend de manière annulaire autour d'un trou d'interconnexion IH permet de définir un pixel Pix du détecteur, et les trous IH métallisés réalisent une connexion électrique entre DZ et le contact TLC.

Le document WO2013079603 décrit une méthode de fabrication d'un détecteur 20 à base de diodes « loop hole » tel que décrit ci-dessus, avec une couche absorbante AL en matériau III-V. Un exemple est une couche absorbante en InGaAs dopée n disposée entre deux couches d'encapsulation en InP. Le détecteur 20 du document WO2013079603 présente une configuration d'illumination spécifique à travers le substrat, et un double imageur Visible/IR.

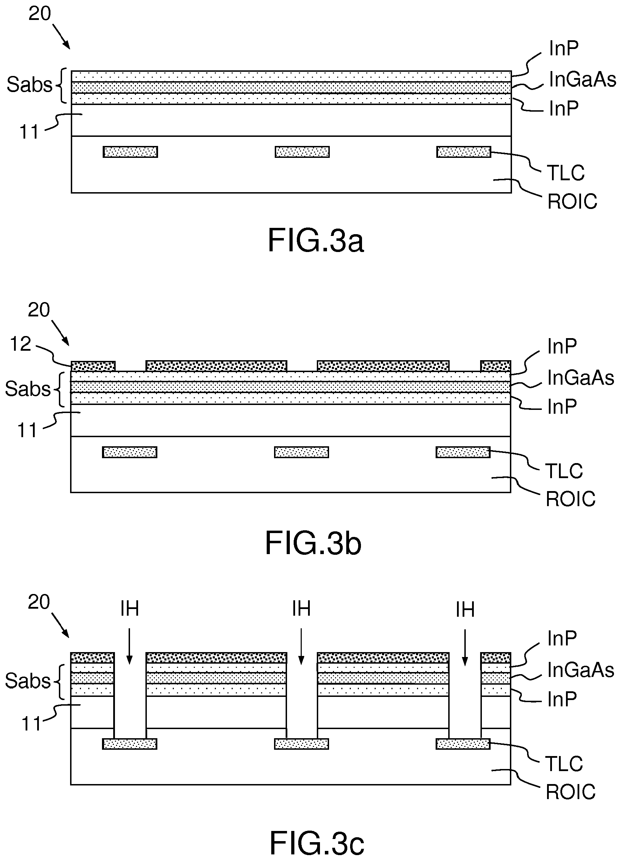

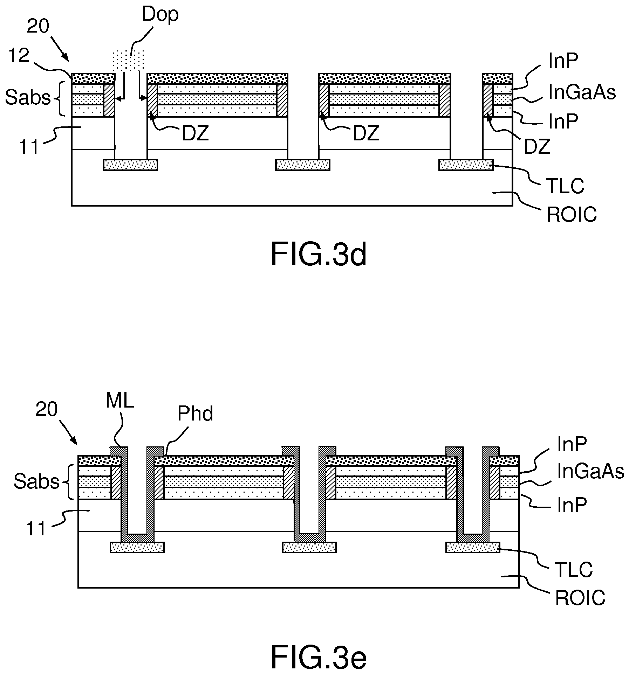

Le principe du procédé pour réaliser un détecteur de type « loop hole » est illustré figure 3.

Dans une première étape illustrée figure 3a une structure semi-conductrice Sabs comprenant la couche absorbante AL entre deux couches barrières est assemblée par collage, via une couche d'assemblage 11, à un circuit de lecture ROIC présentant des contacts enterrés TLC. Puis on dépose un diélectrique de masquage 12 sur la structure Sabs, et on effectue une gravure d'une partie de la couche diélectrique de masquage en regard des contacts TLC tel que représenté figure3b.

Les trous d'interconnexion IH sont réalisés par gravure verticale jusqu'aux contacts TLC, au travers de la structure absorbante et de la couche d'assemblage tel qu'illustré figure 3c. La gravure est réalisée par voie sèche ou par voie humide.

Lors d'une étape illustrée figure 3d, on réalise une zone dopée DZ, par exemple de type p, par diffusion ou implantation ionique d'un dopant Dop via chaque trou IH, de manière à former une photodiode PhD comprenant une jonction p-n cylindrique. La diffusion s'opère à partir de la surface des parois du trou IH, et en parallèle au travers de toutes les couches composant la structure absorbante.

Dans une étape finale illustrée figure 3e on procède au dépôt d'une couche métallique ML sur les parois des trous IH de manière à mettre en contact électrique la zone dopée DZ et le contact TLC.

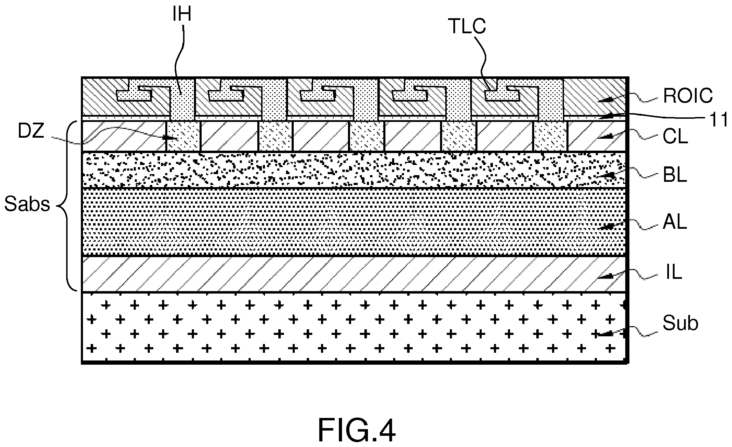

Dans un deuxième type de détecteur IR, illustré figure 4, les trous d'interconnexion IH ne sont pas réalisés de manière à traverser la structure absorbante comme dans la structure « loop hole » mais traversent le circuit de lecture ROIC de type CMOS. Nous dénommerons cette variante TSV pour « Through Silicon Via » en anglais. Ce type de détecteur est décrit dans la demande de brevet FR3053838 A1.

La structure absorbante Sabs, déposée sur un substrat Sub, comprend dans ce cas : une couche active absorbante AL, une couche d'interface IL déposée entre le substrat et la couche active, dont le rôle est d'assurer un bon contact électrique commun tout en limitant la génération de courant d'obscurité ; une couche barrière BL déposée sur la couche absorbante et une couche de contact CL, déposée sur la couche barrière, comprenant les zones dopées DZ.

L'épaisseur globale de la structure le long de la direction d'empilement est comprise entre 0.5 et 10 µm.

On crée la diode par l'empilement des couches verticales, notamment en utilisant une barrière, sans avoir besoin du dopage pour fabriquer la diode (contrairement à la technologie Loop hole) mais seulement pour définir le contact. De manière classique le gap de la couche active est le plus souvent inférieur au gap du substrat et inférieur au gap de la couche d'interface.

Pour la fabrication d'un tel détecteur, après l'assemblage entre la structure absorbante et le circuit de lecture ROIC, les trous d'interconnexion IH sont gravés au travers du circuit de lecture. Dans ce cas le substrat initial en silicium sur lequel était réalisé le circuit ROIC a été aminci (substrat aminci non représenté).

Puis les zones dopées DZ sont réalisées par dopage de la couche de contact CL au travers des via IH, par exemple par diffusion ou implantation. Enfin une étape de finalisation de la connectique consiste à réaliser les contacts pour chaque pixel en remplissant les trous IH d'un matériau métallique et en raccordant ce métal avec les contacts TLC.

Préférentiellement la couche absorbante AL de la structure absorbante (pour les deux variantes « loop hole » et « TSV ») est constituée d'un alliage III-V, mais peut également être un matériau II-VI telle HgCdTe.

Des exemples de matériau constituant la couche AL sont : InGaAs / InP; InAsSb ; super réseau InAsSb/lnAs ; InSb ; super réseau GaSb/InAs ; GaN ; AIGaN, AllnN, AlGaAsSb ; multi-puits quantiques GaAs/AlGaAs ou InGaAs/AllnAs. Le matériau est choisi en fonction de la plage de longueur d'onde de sensibilité souhaitée. Les matériaux des couches adjacentes sont adaptés au matériau de la couche AL.

Chaque couche composant la structure absorbante Sabs est, de manière classique, en accord de maille ou en quasi accord de maille avec la ou les couches adjacentes.

La structure absorbante est réalisée par épitaxie des couches sur un substrat initial Sub.

En variante le substrat Sub de la figure 4 n'est pas le substrat initial. Celui-ci a été retiré et remplacé par un substrat plus rigide présentant une tenue mécanique améliorée, par exemple du silicium ou tout autre matériau rigide utilisé dans les procédés technologiques de fabrication industrielle de circuits intégrés. Cette étape de remplacement est effectuée une fois la structure absorbante collée au circuit de lecture (voir figure 1).

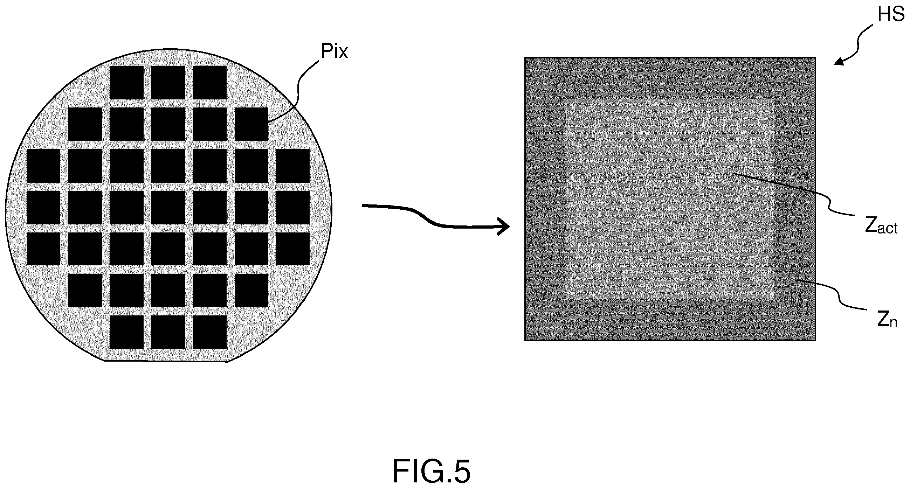

On remarquera par ailleurs que les systèmes hybride « grande surface », par exemple les détecteurs ou les afficheurs, présentent un ensemble de pixels Pix souvent agencés selon une matrice, comme illustré figure 5. Le système hybride HS présente alors une zone centrale active Zact, c'est-à-dire fonctionnelle, et sur la périphérie une zone non fonctionnelle Zn.

La réalisation d'une matrice de photodiode « loop-hole » pour un imageur demande la réalisation sur une grande surface (>1 mm²) d'un grand nombre de pixels homogènes et leurs connexions au circuit de lecture. La réalisation de ces pixels se fait par gravure de via de connexion de diamètre d1, puis par la diffusion à environ 400°C de zinc afin de doper localement chaque via. En outre d'autres étapes du procédé (pour le « loop hole » ou le TSV) sont susceptibles d'être réalisées à des températures de cet ordre de grandeur : dépôt d'un diélectrique, recuit d'activation, recuit de contact...

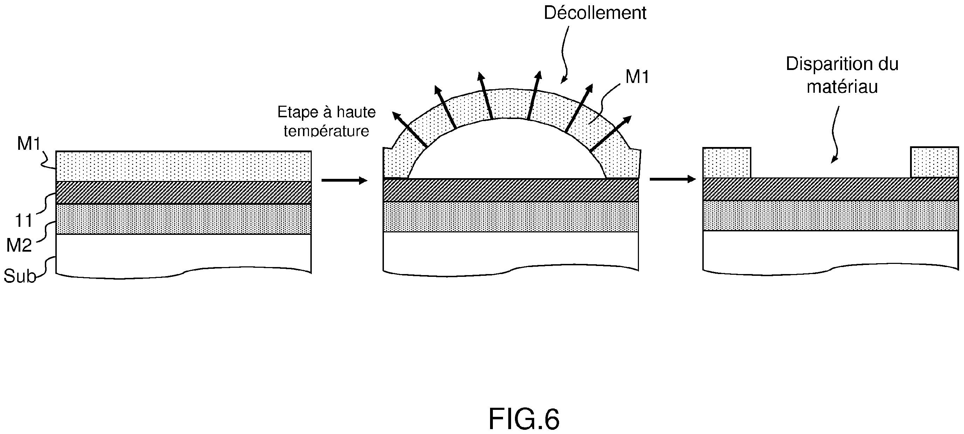

Or les inventeurs ont remarqué que lors d'une montée en température supérieure à 300 °C de la structure hybride collée, la couche reportée de matériau III-V (matériau M1) peut se décoller du circuit de lecture (matériau M2 : silicium) déposé sur un substrat Sub (également en silicium s'il n'y a pas eu remplacement), tel qu'illustré figure 6. Ce décollement peut aller jusqu'à l'éclatement local de M1, laissant des zones dépourvues de matériau M1. De manière générale on emploiera le terme de « bulle » pour qualifier les zones perturbées. La présence de ces bulles est bien entendu très préjudiciable au bon fonctionnement du système hybride et à la suite du procédé de fabrication.

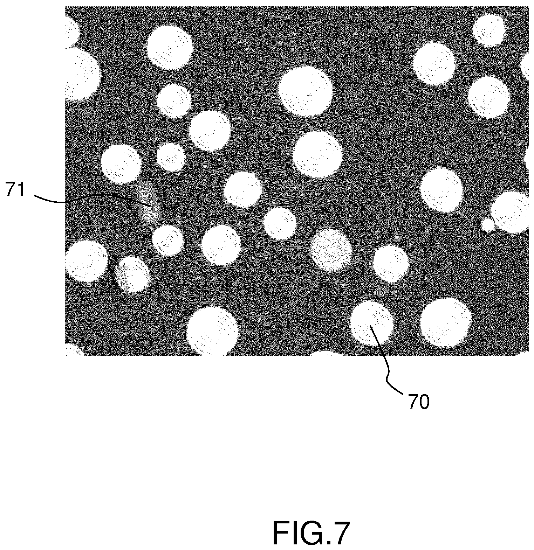

La figure 7 illustre une photographie de la zone de collage d'un système hybride de type détecteur « loop hole » tel qu'illustré figure 2 après l'étape de diffusion du zinc à haute température. Le détecteur est constitué de :
Sub et ROIC matériau M2 : Si
Matériau de collage M3 : SiO₂
Structure absorbante : InP/ InGaAs (AL) / InP, soit un matériau M1 InP et un matériau M1' InGaAs, tous deux étant des matériaux III-V.
Couche de passivation : SiN

Les bulles 70 blanches correspondent à des zones qui ont perdu le matériau M1, et la bulle 71 correspond à une zone avec un matériau M1 décollé et sous contrainte. Ces bulles ont typiquement un diamètre compris entre 10 et 100 µm.

Les inventeurs ont par ailleurs remarqué que ces bulles apparaissent principalement dans les zones dépourvues de via d'interconnexion, c'est-à-dire de pixels, qui sont donc des zones non fonctionnelles, dénommées zones neutres, situées à la périphérie du détecteur (voir figure 5). Les zones avec des via en sont totalement exemptes.

Ces zones neutres sont des zones sans structuration, sans motif, c'est-à-dire sans couches spatialement délimitées. Cela ne signifie pas que ces zones sont inutiles pour le circuit de lecture, seulement ces surfaces ne possèdent pas de motif « top level » pour la connexion à la structure absorbante ou aux connexions finales du composants. Il existe des structures/composants électroniques à des niveaux plus profonds. Et on constate que des bulles apparaissent aux niveaux de toutes ces surfaces, dégradant fortement la qualité des étapes de photolithographie, la matrice et finalement ses performances.

Plusieurs hypothèses pourraient expliquer l'origine de ces bulles.

Une première hypothèse est que ce phénomène est dû à un dégazage (dihydrogène, eau ...) de la silice de collage ou de circuit. Dans les zones non structurées, le gaz s'accumule pour former des bulles, rompant alors le collage entre le circuit et l'empilement III-V. Par contre dans les zones structurées, les via feraient office de cheminés d'évacuation de ce gaz, limitant fortement la formation de bulle.

Une seconde hypothèse à ce phénomène serait que du fait de la forte différente de dilatation thermique entre le silicium et les matériaux III-V (2,6.10⁻⁶ °C⁻¹ pour le silicium et 4,6.10⁻⁶ °C⁻¹ pour l'InP), les fortes montées en température augmenteraient les contraintes sur l'interface de collage et ainsi rompraient les liaisons, formant les bulles. Les zones avec vias, permettraient de diminuer ces contraintes en donnant du volume disponible et ainsi empêcher la formation de via.

Bien entendu ces deux hypothèses peuvent chacune contribuer au phénomène.

En se basant sur ces études et hypothèses, il est proposé un système hybride selon l'invention qui possède des « trous » dans les zones qui en sont normalement dépourvues. Ce concept est applicable à tout système hybride « grande surface », y compris ceux pour lesquels la zone fonctionnelle ne présente pas de via. Dans tous les cas la présence de trous permet de réduire l'apparition de ces bulles.

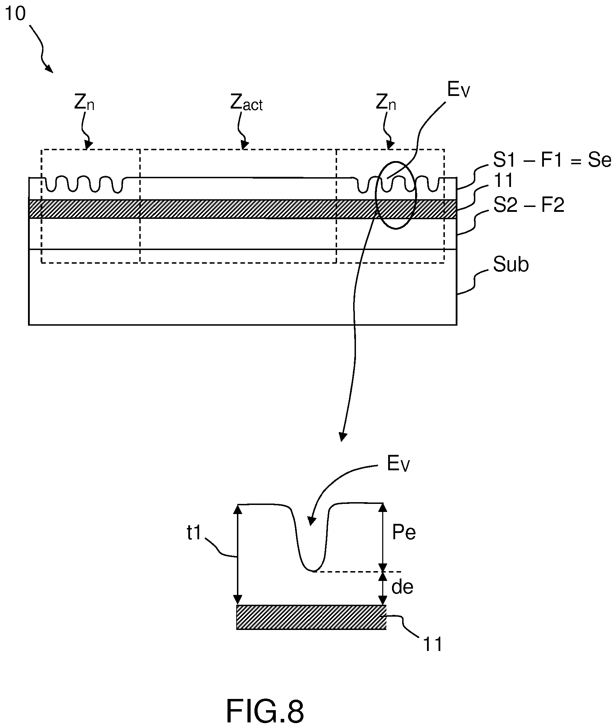

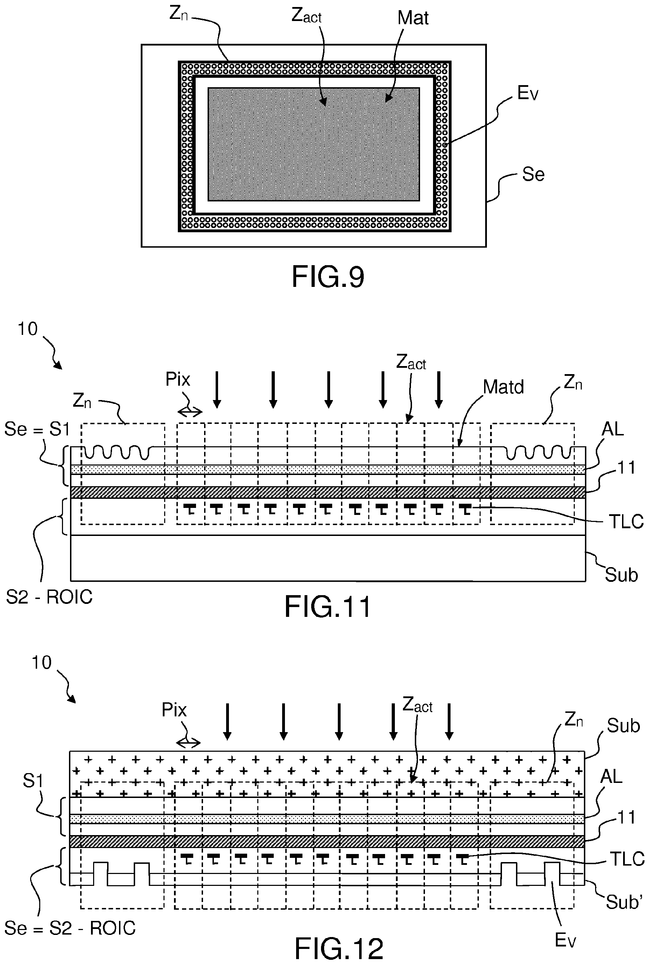

Un système hybride 10 selon l'invention est illustré en coupe figure 8, et en vue de dessus figure 9, du côté présentant les trous de profondeur Pe.

Le système hybride 10 selon l'invention est optique et/ou électronique comme expliqué plus haut.

Il comprend : une première structure planaire S1 présentant une première fonctionnalité réalisée dans au moins un premier matériau M1 et une deuxième structure S2 planaire présentant une deuxième fonctionnalité réalisée dans au moins un deuxième matériau M2 différent du premier matériau. Par exemple pour une fonctionnalité de type détecteur, la structure correspondante peut être constituée d'une pluralité de couches de matériaux différents mais en accord de maille, tel InP/InGaAs/InP. On a donc un matériau M1 en InP et un matériau M'1 en InGaAs. Pour une fonctionnalité de type circuit, la variante la plus commune est un circuit réalisé dans du silicium

La première et la deuxième structure planaire sont assemblées par une couche d'assemblage 11, au moins une des structures planaires étant disposée sur un substrat rigide Sub. Lorsque le système comprend une fonctionnalité circuit (génération / collecte/traitement d'un signal électrique) le substrat Sub est alors également du silicium (s'il n'a pas été remplacé).

En outre comme vu plus haut, le système hybride 10 comprend au moins une zone active Zact utilisée pour mettre en oeuvre les fonctionnalités, et au moins une zone neutre Zn non utilisée pour mettre en oeuvre ces fonctionnalités et disposée en périphérie de ladite zone active.

Le système hybride est préférentiellement « grande surface », c'est-à-dire avec une surface de la zone utile centrale d'au moins 1 mm².

Enfin le système comprend en outre des évidements Ev réalisés dans au moins une zone neutre Zn de la structure planaire qui n'est pas disposée sur le substrat rigide, dénommée structure planaire évidée Se.

Les évidements sont disposés dans des zones non fonctionnelles et en périphérie, et donc ne perturbent pas le fonctionnement du système. Il s'agit de simples « trous » qui n'ont aucune fonctionnalité électrique. Leur fonction est de permettre le dégazage et/ou la relaxation des contraintes thermiques afin de réduire voir supprimer les bulles précédemment décrites.

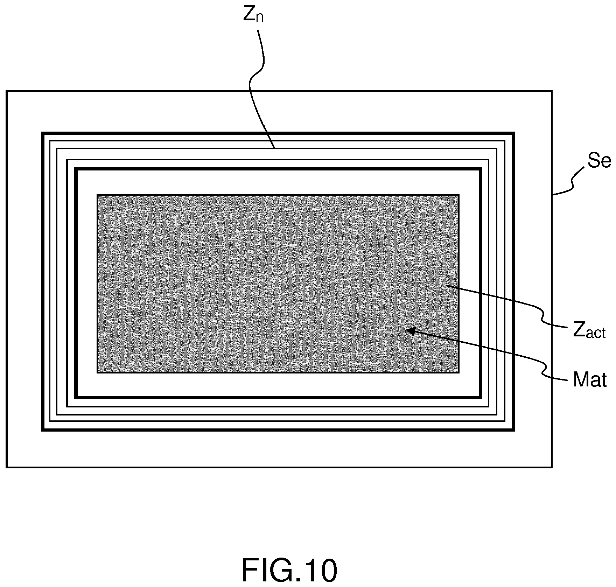

On utilise le terme « évidement » car ceux-ci peuvent prendre toute forme adaptée. Par exemple, ils peuvent prendre la forme de trous tel qu'illustré figure 9, selon diverses variantes telles que cylindrique, de base circulaire, carré, triangulaire, pentagonale ... ou conique, ou de sillons tel qu'illustré figure 10. L'important est de réaliser des cavités dans une des structures permettant l'évacuation du dihydrogène et/ou le relâchement des contraintes mécaniques dues au différentiel de dilatation entre M1 et M2.

Pour en faciliter la fabrication les évidements sont préférentiellement réalisés dans la structure Se la moins épaisse, c'est-à-dire celle qui n'est pas disposée sur le substrat rigide Sub qui supporte le système. Préférentiellement la structure planaire évidée Se présente une épaisseur inférieure à 20 µm.

La profondeur Pe des évidements est fonction de l'épaisseur de la structure Se, et cette épaisseur peut varier entre 1 µm et 20 µm. Préférentiellement, la profondeur Pe des évidements Ev est telle qu'un fond dudit évidement est disposé à une distance « de » de la couche d'assemblage inférieure à 1µm. Les inventeurs ont montré qu'il n'est pas nécessaire pour obtenir la suppression des bulles que l'évidement atteigne la couche d'assemblage 11, il suffit de s'en approcher suffisamment pour obtenir l'effet souhaité. Cela permet de réaliser des évidements moins profonds qui ne risquent pas d'endommager la structure du dessous, tel un composant du circuit.

Lorsque les évidements sont réalisés dans des détecteurs utilisant des via d'interconnexion IH, ils peuvent être réalisés lors de l'étape de gravure de ces via. Ils subiront ensuite toutes les autres étapes du procédé, et donc dans cette variante les évidements sont métallisés, c'est-à-dire recouverts d'une couche métallique, comme les IH.

Selon un mode de réalisation, pour obtenir un bon relâchement des contraintes thermiques, le matériau de la structure planaire évidée Se présente un coefficient de dilatation thermique supérieur au coefficient de dilatation thermique de l'autre structure planaire. Pour un détecteur « loop hole » InP/GalnAs/lnP sur ROIC Silicium, avec les trous Ev du côté des via IH du détecteur cette condition est réalisée (2,6.10⁻⁶ °C⁻¹ pour le silicium et 4,6.10⁻⁶ °C⁻¹ pour l'InP).

Préférentiellement l'assemblage est réalisé par collage moléculaire. La couche d'assemblage comprend alors préférentiellement de la silice.

La figure 11 illustre une première variante d'un système optoélectronique de détection 10 selon l'invention comprenant une matrice de pixels Matd.

La première fonctionnalité est une photo-génération pixélisée de porteurs, la première structure S1 comprenant une pluralité de couches dont une couche absorbante AL en matériau semi-conducteur II-VI ou III-V, et dans lequel la deuxième fonctionnalité est une lecture d'un signal généré par un pixel, la deuxième structure S2 comprenant un circuit de lecture ROIC qui comprend des contacts TLC enterrés.

Une zone active Zact comprend la matrice de pixels Matd et une zone neutre Zn est disposée en périphérie de la matrice de pixels.

Les évidements sont réalisés dans la première structure, et le substrat Sub est le substrat du circuit ROIC, typiquement en silicium.

La figure 12 illustre une deuxième variante d'un système optoélectronique de détection 10 selon l'invention comprenant une matrice de pixels Matd.

Le substrat rigide Sub est ici le substrat des couches de détection, soit le substrat initial en InP soit un substrat de remplacement, tel que le silicium. Les évidements sont réalisés dans la deuxième structure ROIC, et les évidements traversent le substrat en silicium aminci Sub' du circuit ROIC et au moins une partie du circuit lui-même.

Selon un mode de réalisation, applicable aux deux variantes ci-dessus, la première structure S1 du système hybride optoélectronique de détection comprend dans au moins une couche une pluralité de zones dopées DZ configurées pour collecter des porteurs photogénérés par la couche absorbante, une zone dopée permettant de définir un pixel Pix du système de détection.

Le signal électrique est alors généré par un pixel à partir des porteurs photogénérés par la couche absorbante AL, et la connexion électrique entre une zone dopée DZ et un contact TLC enterré du circuit de lecture ROIC est réalisée via des trous d'interconnexion IH métallisés.

La structure planaire évidée Se est alors préférentiellement celle qui est traversée par les trous d'interconnexions IH.

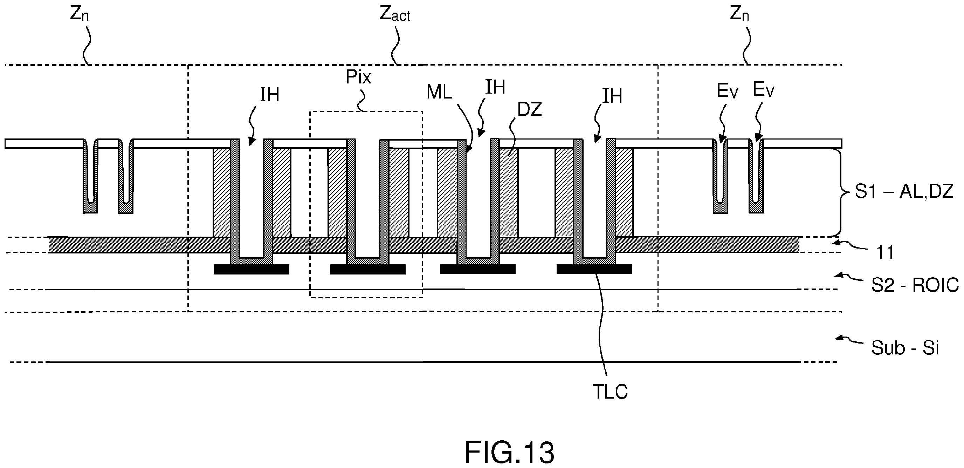

Un système hybride de détection 10 de type « loop hole » selon la première variante et selon le mode de réalisation ci-dessus est illustré figure 13.

La deuxième structure S2 est disposée sur le substrat rigide Sub, les trous d'interconnexion IH traversent la première structure S1, la couche d'assemblage et le circuit de lecture ROIC jusqu'au contact TLC. Chaque zone dopée DZ s'étend de manière annulaire autour d'un trou d'interconnexion IH, et la structure planaire évidée Se est la première structure planaire S1.

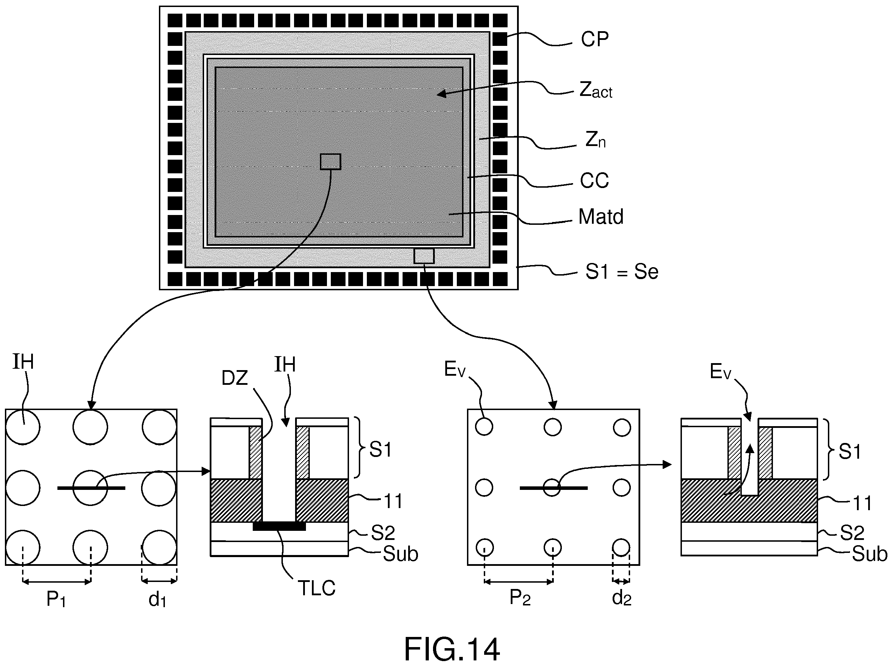

Selon un mode de réalisation illustré figure 14, la zone active du système de détection 10 selon l'invention de type « loop hole » matriciel comprend la matrice Matd de pixels Pix et comprend également un contact commun CC autour de la matrice. En périphérie de système on trouve des plots de connexion CP pour le contrôle du circuit de lecture et l'extraction du signal vidéo de l'imageur. Le système présente ainsi une zone neutre Zn non fonctionnelle entre le contact commun CC et les plots de connexion CP dans laquelle sont réalisés les évidements Ev.

Préférentiellement la profondeur pe d'un évidement Ev est telle que celui-ci n'atteint pas le circuit de lecture ROIC, pour ne pas risquer d'endommager celui-ci.

Selon un mode de réalisation les via IH sont des trous circulaires qui présentent un diamètre d1 et une profondeur p1 et les évidements Ev sont également des trous circulaires qui présentent donc une profondeur p2 <p1 et un diamètre d2<d1. En effet lors d'une gravure, il est connu que la profondeur des vias diminue avec leur diamètre, et donc si l'on souhaite obtenir une profondeur d2<d1, il faut que d2 soit inférieur à d1.

Ainsi la création dans les zones sans pixel ni plot de contact du système, de trous de diamètre d2 inférieur au diamètre d1 des via d'interconnexion empêche la formation de bulle de décollement de matériau III-V lors des étapes de fabrication réalisées à des températures supérieures à 300°C.

Ces trous Ev sont préférentiellement réalisés en même temps que les via IH pour Loop-hole. Leur réalisation ne nécessite pas de lithographie spécifique ou bien d'étape de gravure. Le diamètre d1 des via IH est choisi de manière à ce que la profondeur p1 soit telle que IH débouche sur le niveau « top métal » (cas des pixels), et le diamètre d2 des trous Ev est choisi de manière à ce que la profondeur p2 soit telle que Ev débouche au niveau de la silice de collage (dans les zones sans pixels). Les zones non pixellisées ne sont pas couvertes de niveau « top-metal ».

Les trous Ev, réalisés en même temps que les via IH, présentent également une zone dopée DZ et une métallisation (non représentée figure 14).

Un second avantage de ce mode de réalisation est que les surfaces qui étaient libres (sans via), vont alors subir les mêmes mécanismes de fabrication, et homogénéiser la surface de la matrice lors des étapes de fabrication nécessitant l'intervention d'espèces réactives (gravure plasma, diffusion de dopant). On obtient alors une meilleure homogénéité de pixel de la matrice en diminuant les différences entre bord et centre de la matrice.

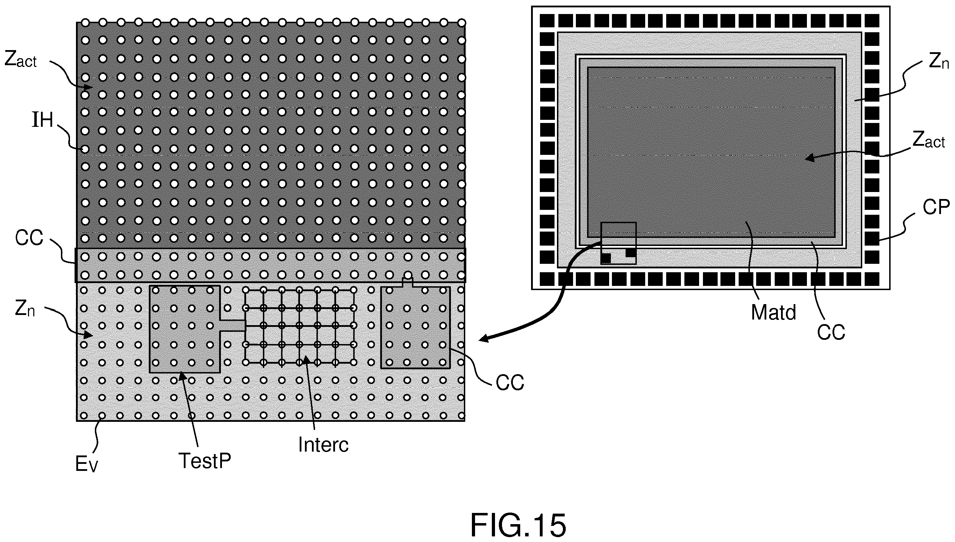

Dans un mode particulier de ce mode de réalisation illustré figure 15 on utilise le fait que les trous Ev présentent les mêmes caractéristiques que les via IH. Des évidements formant une première pluralité sont interconnectés entre eux de manière à former un plot de test TestP et des évidements formant une deuxième pluralité sont reliés entre eux et au contact commun CC de la matrice de pixels Matd. On réalise ainsi un motif de test de surface permettant de vérifier le bon déroulement des gravures de via, du dopage localisé par diffusion et des métallisations.

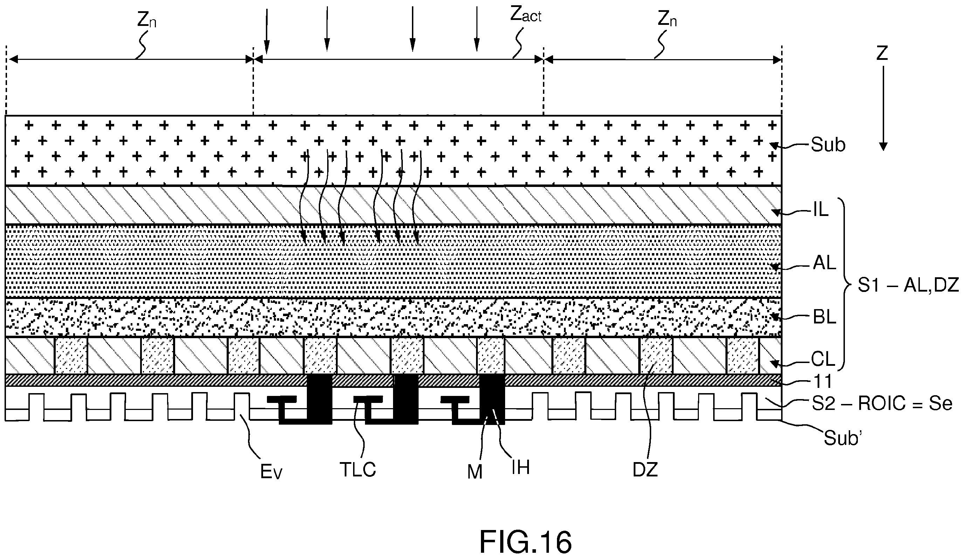

Un système hybride de détection 10 de type TSV selon la deuxième variante (voir figure 12) est illustré figure 16. Les trous d'interconnexion IH traversent le substrat aminci Sub' et la deuxième structure planaire S2. Les évidements Ev sont réalisés du côté du circuit de lecture, au travers du substrat en silicium aminci Sub'. La structure planaire évidée Se est ici la deuxième structure planaire S2. Le substrat rigide Sub ici disposé du côte des rayons lumineux incidents, doit alors être transparent dans la bande spectrale d'intérêt.

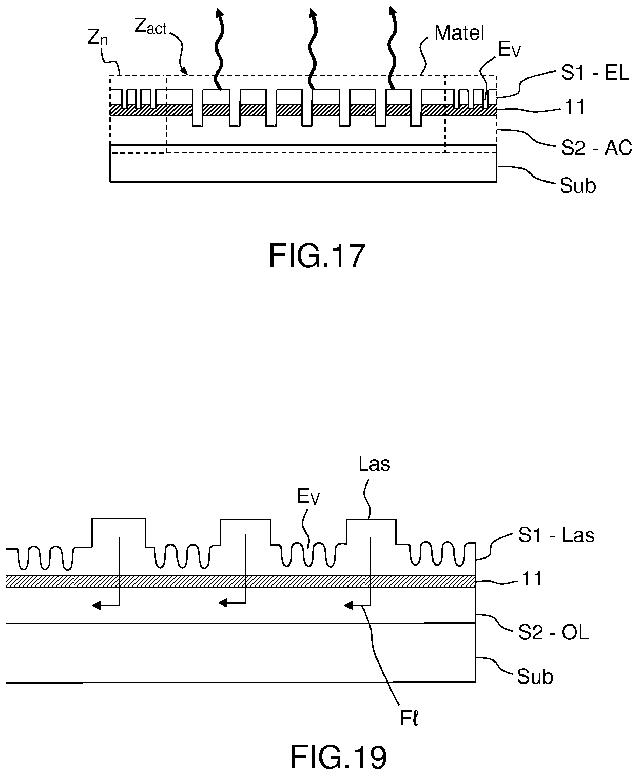

Selon une variante, le système hybride 10 est un système optoélectronique d'affichage comprenant une matrice de pixels électroluminescents Matel, tel qu'illustré figure 17, par exemple de type microdisplay LED. La première fonctionnalité est une émission pixélisée, la première structure planaire S1 comprend une pluralité de couches dont une couche électroluminescente EL. La deuxième fonctionnalité est une génération de signaux électriques adaptés pour réaliser l'émission électroluminescente, la deuxième structure planaire S2 comprenant un circuit d'adressage AC des pixels déposé sur un substrat Sub, préférentiellement en silicium.

L'au moins une zone active Zact comprend la matrice de pixels Mael et l'au moins une zone neutre Zn est disposée en périphérie de ladite matrice de pixels. Préférentiellement la structure évidée Se correspond à S1.

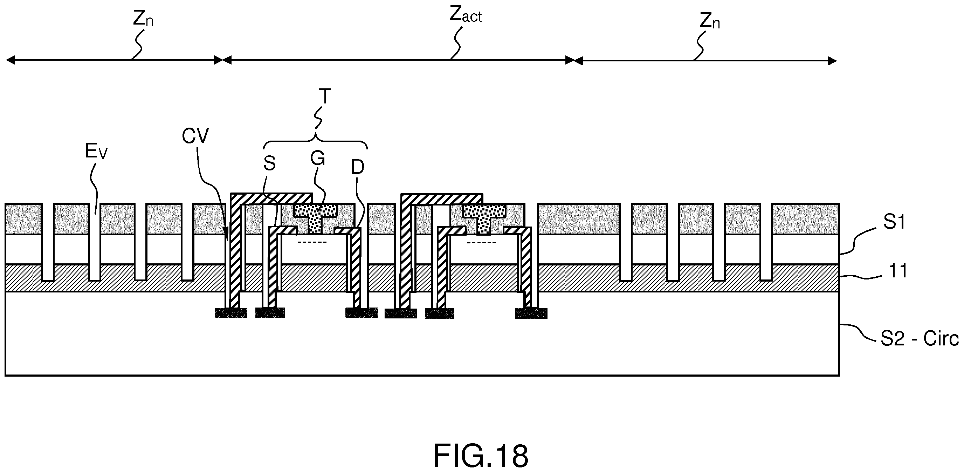

Selon une autre variante le système hybride 10 est un système électronique rapide illustré figure 18, issu de l'intégration hétérogène de matériaux III-V sur un circuit CMOS sur silicium. La première structure planaire S1 comprend une pluralité de transistors T et la deuxième structure planaire S2 comprend des circuits Cire associés auxdits transistors. La zone active Zact comprend les transistors T et la zone neutre Zn dans laquelle sont réalisés les évidements est disposée en périphérie des transistors, la structure évidée Se correspondant à la première structure planaire S1.

Le premier matériau pour les transistors est par exemple du GaN, de l'InP ou du GaAs et le deuxième matériau pour les circuits est par exemple du silicium.

Des transistors bipolaires à hétéro-structure dans du InGaAs/InP permettent d'effectuer des fonctions de conversion analogique rapide jusqu'à quelques dizaines de GHz. Un collage InP sur un circuit CMOS permet d'associer des fonctions rapides sur InP et numériques sur CMOS.

Selon un mode de réalisation des systèmes d'affichage de la figure 17 ou des systèmes électroniques de la figure 18, la zone active Zact comprend des trous d'interconnexion ou via de connexion CV prenant diverses formes, pour évacuer les bulles qui pourraient se former dans cette zone. Ici également, la réalisation simultanée de via de dégazage, c'est à dire d'évidements Ev, et de via de connexion électrique CV (base, collecteur émetteur dans le cas de transistor bipolaire, grille, drain, source dans le cas d'un transistor à effet de champ) permet d'évacuer des bulles susceptibles de se former lors de l'intégration (assemblage) sur une surface de quelques millimètres carrés.

On cite à titre d'exemple des composants de puissance sur GaAs ou GaN associés à un circuit MMIC avec des via d'interconnexion entre ligne hyperfréquence microstrip et interconnexion des transistors.

Un système optique ou optoélectronique est illustré figure 19. La première fonctionnalité est une émission laser individualisée, la première structure planaire S1 comprenant une pluralité d'émetteurs laser Las, la deuxième fonctionnalité est un traitement des faisceaux optiques FI générés par les émetteurs laser Las. La deuxième structure planaire S2 comprend au moins une couche de traitement optique OL déposée sur le substrat rigide Sub. Les émetteurs lasers sont configurés pour émettre vers la couche OL. La ou les couches de traitement réalisent des fonctions de guidage, multiplexage/démultiplexage, filtrage, amplification ...

Les évidements sont réalisés dans les zones n'ayant pas été éliminées lors de la fabrication des rubans lasers. Ce sont des zones non fonctionnelles, mais qui ont pu être gardées afin de protéger le circuit sous-jacent. Les évidements sont réalisés dans les zones où il n'y a pas de ruban laser mais où il existe toujours du matériau reporté.

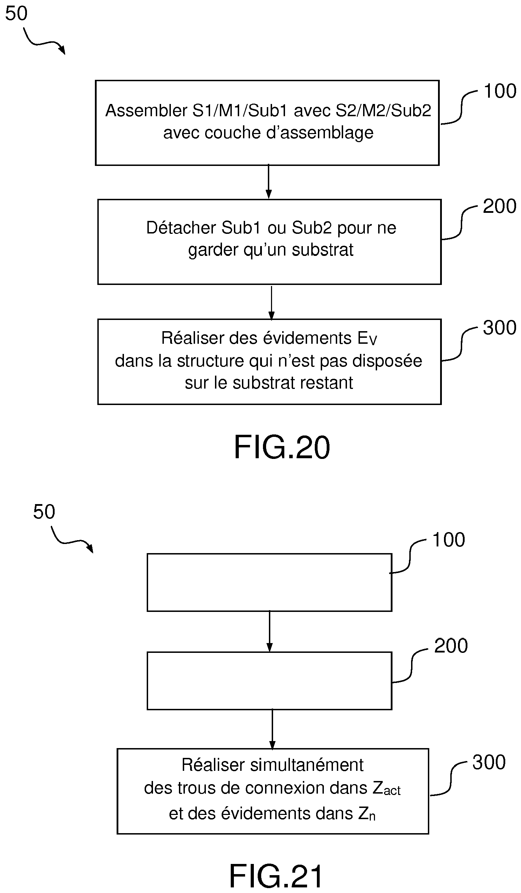

Selon un autre aspect l'invention concerne un procédé 50 de fabrication d'un système hybride optique et/ou électronique hybride, illustré figure 20. Le procédé comprend une première étape 100 consistant à assembler par une couche d'assemblage 11 d'une part une première structure planaire S1 présentant une première fonctionnalité réalisée dans au moins un premier matériau M1, S1 étant déposée sur un premier substrat Subi, et d'autre part une deuxième structure S2 planaire présentant une deuxième fonctionnalité réalisée dans au moins un deuxième matériau M2 différent du premier matériau, S2 étant déposée sur un deuxième substrat Sub2.

Les première et deuxième structures assemblées comprennent au moins une zone active (Zact) utilisée pour mettre en oeuvre lesdites fonctionnalités, et au moins une zone neutre (Zn) non utilisée pour mettre en oeuvre lesdites fonctionnalités.

Dans une deuxième étape 200 on détache au moins un des substrats pour ne conserver qu'un seul substrat rigide Sub1 ou Sub2. Dans une variante, le procédé 50 comprend en outre une étape 250 de remplacement du substrat Sub1 ou Sub 2 restant par un substrat de destination Subd (voir figure 1).

Ces deux étapes ont été décrites plus haut (voir figure 1).

Dans une troisième étape 300 on réalise des évidements Ev dans au moins une zone neutre Zn de la structure planaire qui n'est pas disposée sur le substrat rigide Sub, dénommée structure planaire évidée Se.

Dans une variante illustrée figure 21 du procédé 50 selon l'invention, l'étape 300 de réalisation des évidements consiste à réaliser simultanément des trous d'interconnexion IH ou CV dans l'au moins une zone active Zact au travers d'une des structures planaires, et les évidements Ev dans l'au moins une zone neutre Zn de ladite structure planaire traversée par les trous d'interconnexion. La structure évidée est celle au travers de laquelle on réalise les trous de connexion.

Préférentiellement l'étape de réalisation simultanée des trous d'interconnexion IH, CV et/ou des évidements Ev s'effectue par lithographie puis gravure. La technologie de lithographie est choisie parmi : par faisceau d'électrons ; par nano-impression ; par lithographie optique. La technologie de gravure est choisie parmi gravure ionique, gravure chimique, gravure plasma.

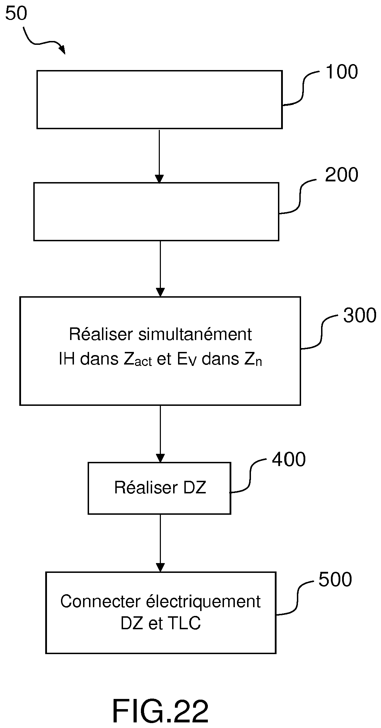

Dans une variante illustrée figure 22 le procédé 50 réalise un détecteur optoélectronique hybride comprenant une matrice de pixels Matd.

La première fonctionnalité est ici une photo-génération pixélisée de porteurs, la première structure S1 comprenant une pluralité de couches dont une couche absorbante AL en matériau semi-conducteur II-VI ou III-V.

La deuxième fonctionnalité étant une lecture d'un signal généré par un pixel, la deuxième structure S2 comprenant un circuit de lecture ROIC destiné à récupérer un signal électrique à partir desdits porteurs photo-générés par la couche absorbante AL et comprenant une pluralité de contacts TLC enterrés. L'au moins une zone active Zact comprend la matrice de pixels, et l'au moins une zone neutre Zn est disposée en périphérie de ladite matrice de pixels. Dans cette variante, l'étape 300 de réalisation des évidements consiste à réaliser simultanément des trous d'interconnexions IH dans l'au moins une zone active Zact au travers d'une des structures planaires, et les évidements Ev dans l'au moins une zone neutre Zn de ladite structure planaire traversée par les trous d'interconnexion.

Selon une variante également illustrée figure 22 le procédé 50 de fabrication d'un détecteur optoélectronique hybride comprend en outre les étapes suivantes, réalisées après l'étape 300 :
Dans une étape 400 on réalise une pluralité de zones dopées DZ configurées pour collecter des porteurs photogénérés par la couche absorbante, une zone dopée permettant de définir un pixel Pix du détecteur. Dans une étape 500 on connecte électriquement chaque zone dopée DZ avec le contact associé TLC du circuit de lecture ROIC via les trous d'interconnexion IH.

Selon un mode de réalisation de cette variante le procédé 50 selon l'invention réalise un détecteur « loop hole ». L'étape 300 de réalisation simultanée des trous d'interconnexion et des évidements s'effectue par gravure de la première structure planaire S1 et, pour les trous d'interconnexion, du circuit de lecture ROIC jusqu'aux contacts enterrés TLC. La structure planaire évidée correspond ici à la première structure planaire.

Selon un autre mode de réalisation de cette variante le procédé 50 selon l'invention réalise un détecteur TSV. L'étape 300 de réalisation simultanée des trous d'interconnexion et des évidements s'effectue par gravure du substrat aminci Sub' sur lequel le circuit de lecture ROIC est déposé et par gravure, au moins partiellement, du circuit de lecture ROIC. La structure planaire évidée Se correspond ici à la deuxième structure S2.

## Revendications

1. Système optique et/ou électronique (10) hybride comprenant une matrice de pixels (Matd, Matel) et comprenant :-une première structure planaire (S1) présentant une première fonctionnalité réalisée dans au moins un premier matériau (M1), ladite première fonctionnalité étant une photogénération pixelisée de porteurs ou une émission électroluminescente pixelisée,
- une deuxième structure (S2) planaire présentant une deuxième fonctionnalité réalisée dans au moins un deuxième matériau (M2) différent du premier matériau, ladite deuxième fonctionnalité étant une lecture d'un signal électrique généré par un pixel lorsque la première fonctionnalité est une photogénération pixelisée de porteurs ou une génération de signaux électriques adaptés pour réaliser ladite émission électroluminescente lorsque la première fonctionnalité est une émission électroluminescente pixelisée,
- la première et la deuxième structure planaire étant assemblées par une couche d'assemblage (11), au moins une des structures planaires étant disposée sur un substrat rigide (Sub),
- le système comprenant au moins une zone active (Zact) utilisée pour mettre en oeuvre lesdites fonctionnalités et comprenant ladite matrice de pixels, et au moins une zone neutre (Zn) non utilisée pour mettre en oeuvre lesdites fonctionnalités et disposée en périphérie de ladite zone active,
- le système comprenant en outre des évidements (Ev) réalisés dans au moins une zone neutre de la structure planaire qui n'est pas disposée sur le substrat rigide, dénommée structure planaire évidée (Se), ladite au moins une zone neutre dans laquelle sont réalisés les évidements étant localisée en périphérie de ladite matrice de pixels et les évidements (Ev) n'ont aucune fonctionnalité électrique.

2. Système selon la revendication 1 dans lequel une profondeur d'un évidement (pe) est telle qu'un fond dudit évidement est disposé à une distance (de) de la couche d'assemblage inférieure à 1µm.

3. Système selon l'une des revendications 1 ou 2 dans lequel les évidements présentent la forme de trous ou de sillons.

4. Système selon l'une des revendications précédentes dans lequel les évidements sont recouverts d'une couche métallique.

5. Système selon l'une des revendications précédentes dans lequel le matériau de la structure planaire évidée (Se) présente un coefficient de dilatation thermique supérieur au coefficient de dilatation thermique de l'autre structure planaire.

6. Système selon l'une des revendications précédentes dans lequel la structure planaire évidée présente une épaisseur inférieure à 20 µm.

7. Système selon l'une des revendications précédentes dans lequel l'assemblage est réalisé par collage moléculaire.

8. Système selon l'une des revendications précédentes dans lequel une surface de l'au moins une zone active est supérieure ou égale à 1 mm².

9. Système optoélectronique de détection (10) selon l'une des revendications précédentes comprenant une matrice de pixels (Matd),
dans lequel la première fonctionnalité est une photo-génération pixélisée de porteurs, la première structure (S1) comprenant une pluralité de couches dont une couche absorbante (AL) en matériau semi-conducteur II-VI ou III-V, dans lequel la deuxième fonctionnalité est une lecture d'un signal électrique généré par un pixel, la deuxième structure (S2) comprenant un circuit de lecture (ROIC) comprenant une pluralité de contacts (TLC) enterrés,
et dans lequel l'au moins une zone active (Zact) comprend ladite matrice de pixels et l'au moins une zone neutre (Zn) est disposée en périphérie de ladite matrice de pixels.

10. Système optoélectronique de détection (10) selon la revendication 9 dans lequel la première structure (S1) comprend dans au moins une couche une pluralité de zones dopées (DZ) configurées pour collecter des porteurs photogénérés par la couche absorbante, une zone dopée permettant de définir un pixel (Pix) du système de détection, dans lequel le signal électrique est généré par un pixel à partir desdits porteurs photogénérés par la couche absorbante (AL), une connexion électrique entre une zone dopée (DZ) et un contact (TLC) enterré du circuit de lecture (ROIC) étant réalisée via des trous d'interconnexion (IH) métallisés, et dans lequel la structure planaire évidée (Se) est celle qui est traversée par les trous d'interconnexions.

11. Système optoélectronique de détection (10) selon la revendication 10 dans lequel la deuxième structure (S2) est disposée sur le substrat rigide (Sub), dans lequel les trous d'interconnexion (IH) traversent la première structure (S1) et le circuit de lecture (ROIC) jusqu'au contact (TLC), dans lequel chaque zone dopée (DZ) s'étend de manière annulaire autour d'un trou d'interconnexion, la structure planaire évidée (Se) étant la première structure planaire (S1).

12. Système optoélectronique de détection (10) selon l'une des revendications 10 ou 11 dans lequel une profondeur d'un évidement (Pe) est telle que ledit évidement n'atteint pas le circuit de lecture.

13. Système optoélectronique de détection (10) selon l'une des revendications 9 à 12 dans lequel les évidements sont réalisés dans la zone neutre (Zn) disposée entre un contact commun (CC) et des plots de contact (CP) dudit système.

14. Système optoélectronique de détection (10) selon la revendication 13 dans lequel une première pluralité d'évidements sont interconnectés entre eux de manière à former un plot de test (TestP) et dans lequel une deuxième pluralité d'évidements sont reliés entre eux et audit contact commun (CC) de la matrice de pixels (Matd).

15. Système optoélectronique de détection selon l'une des revendications 9 ou 10 dans lequel la première structure planaire (S1) est disposée sur le substrat rigide (Sub), ledit substrat rigide étant transparent, dans lequel chaque zone dopée (DZ) est réalisée dans une couche de contact (CL) disposée sous la couche absorbante (AL),
dans lequel la deuxième structure planaire (S2) est disposée sur un substrat aminci (Sub'),
dans lequel les trous d'interconnexion (IH) traversent le substrat aminci (Sub') et la deuxième structure planaire (S2), la structure planaire évidée (Se) étant la deuxième structure planaire (S2), les évidements étant réalisés dans le substrat aminci (Sub') et la deuxième structure planaire (S2).

16. Système optoélectronique d'affichage selon l'une des revendications 1 à 8 comprenant une matrice de pixels électroluminescents (Matel),
dans lequel la première fonctionnalité est une émission pixélisée, la première structure planaire (S1) comprenant une pluralité de couches dont une couche électroluminescente,
dans lequel la deuxième fonctionnalité est une génération de signaux électriques adaptés pour réaliser l'émission électroluminescente, la deuxième structure planaire (S2) comprenant un circuit d'adressage (AC) des pixels déposé sur un substrat en silicium, et dans lequel l'au moins une zone active (Zact) comprend ladite matrice de pixels (Matel) et l'au moins une zone neutre (Zn) est disposée en périphérie de ladite matrice de pixels, la structure évidée (Se) correspondant à la première structure planaire (S1).

17. Système électronique selon l'une des revendications 1 à 8 dans lequel la première structure planaire (S1) comprend une pluralité de transistors (T) et la deuxième structure planaire comprend des circuits (Cire) associés auxdits transistors, et dans lequel l'au moins une zone active (Zact) comprend lesdits transistors et l'au moins une zone neutre (Zn) est disposée en périphérie desdits transistors, la structure évidée (Se) correspondant à la première structure planaire (S1).

18. Système selon l'une des revendications 16 ou 17 comprenant en outre des via d'interconnexion (CV) dans la zone active.

19. Procédé (50) de fabrication d'un système hybride optique et/ou électronique hybride, le procédé comprenant les étapes consistant à :
- Assembler (100), par une couche d'assemblage (11), une première structure planaire (S1) présentant une première fonctionnalité et comprenant une matrice de pixels réalisée dans au moins un premier matériau (M1), ladite première fonctionnalité étant une photogénération pixelisée de porteurs ou une émission électroluminescente pixelisée, la première structure (S1) étant déposée sur un premier substrat (Sub1), et une deuxième structure (S2) planaire présentant une deuxième fonctionnalité réalisée dans au moins un deuxième matériau (M2) différent du premier matériau, la deuxième structure (S2) étant déposée sur un deuxième substrat (Sub2), ladite deuxième fonctionnalité étant une lecture d'un signal électrique généré par un pixel lorsque la première fonctionnalité est une photogénération pixelisée de porteurs ou une génération de signaux électriques adaptés pour réaliser ladite émission électroluminescente lorsque la première fonctionnalité est une émission électroluminescente pixelisée,
les première et deuxième structures assemblées comprenant au moins une zone active (Zact) utilisée pour mettre en oeuvre lesdites fonctionnalités, et au moins une zone neutre (Zn) non utilisée pour mettre en oeuvre lesdites fonctionnalités, ladite zone active comprenant la matrice de pixels,
- Détacher (200) un des substrats de manière à ne conserver qu'un seul substrat rigide (Sub1, Sub2),
- Réaliser (300) des évidements (Ev) dans au moins une zone neutre (Zn) de la structure planaire qui n'est pas disposée sur le substrat rigide, dénommée structure planaire évidée (Se), ladite au moins une zone neutre dans laquelle sont réalisés les évidements étant localisée en périphérie de ladite matrice de pixels et les évidements n'ont aucune fonctionnalité électrique.

20. Procédé (50) selon la revendication 19 comprenant en outre une étape (250) de remplacement du substrat restant par un substrat de destination (Subd).

21. Procédé (50) de fabrication selon l'une des revendications 19 ou 20 d'un détecteur optoélectronique hybride comprenant une matrice de pixels (Matd), la première fonctionnalité étant une photo-génération pixélisée de porteurs, la première structure (S1) comprenant une pluralité de couches dont une couche absorbante (AL) en matériau semi-conducteur II-VI ou III-V,
la deuxième fonctionnalité étant une lecture d'un signal généré par un pixel, la deuxième structure (S2) comprenant un circuit de lecture (ROIC) destiné à récupérer un signal électrique à partir desdits porteurs photo-générés par la couche absorbante (AL) et comprenant une pluralité de contacts (TLC) enterrés,
l'au moins une zone active (Zact) comprenant la matrice de pixels, et l'au moins une zone neutre (Zn) étant disposée en périphérie de ladite matrice de pixels,
l'étape de réalisation des évidements (300) consistant à réaliser simultanément des trous d'interconnexions (IH) dans l'au moins une zone active (Zact) au travers d'une des structures planaires, et lesdits évidements (Ev) dans l'au moins une zone neutre (Zn) de ladite structure planaire traversée par les trous d'interconnexion.

22. Procédé (50) de fabrication selon l'une des revendications 19 à 21 d'un détecteur optoélectronique hybride comprenant en outre les étapes consistant à :
- Réaliser (400) une pluralité de zones dopées (DZ) configurées pour collecter des porteurs photogénérés par la couche absorbante, une zone dopée permettant de définir un pixel (Pix) du détecteur,
- Connecter électriquement (500) chaque zone dopée (DZ) avec le contact associé (TLC) du circuit de lecture (ROIC) via les trous d'interconnexion (IH).

23. Procédé selon l'une des revendications 21 à 22 dans lequel l'étape de réalisation simultanée des trous d'interconnexion et des évidements s'effectue par gravure de la première structure planaire (S1) et, pour les trous d'interconnexion, du circuit de lecture (ROIC) jusqu'aux contacts enterrés (TLC), la structure planaire évidée correspondant à la première structure planaire.

24. Procédé selon l'une des revendications 21 à 22 dans lequel l'étape de réalisation simultanée des trous d'interconnexion et des évidements s'effectue par gravure du substrat aminci (Sub') sur lequel le circuit de lecture est déposé et au moins partiellement du circuit de lecture (ROIC), la structure planaire évidée correspondant à la deuxième structure.

25. Procédé selon l'une des revendications 21 à 24 dans lequel l'étape de réalisation simultanée des trous d'interconnexion (IH) et des évidements (Ev) s'effectue par lithographie puis gravure, la technologie de lithographie étant choisie parmi : par faisceau d'électrons ; par nano-impression ; par lithographie optique, et la technologie de gravure étant choisie parmi la gravure ionique, gravure chimique ou plasma.

## Patentansprüche

1. Hybrides optisches und/oder elektronisches System (10), umfassend eine Pixelmatrix (Matd, Matel) und Folgendes umfassend:
- eine erste planare Struktur (S1) mit einer ersten Funktionalität, die aus mindestens einem ersten Material (M1) hergestellt ist, wobei die erste Funktionalität eine pixelierte Photogeneration von Trägern oder eine pixelierte Elektrolumineszenzemission ist,
- eine zweite planare Struktur (S2) mit einer zweiten Funktionalität, die aus mindestens einem zweiten Material (M2) hergestellt ist, das sich von dem ersten Material unterscheidet, wobei die zweite Funktionalität ein Lesen eines von einem Pixel erzeugten elektrischen Signals ist, wenn die erste Funktionalität eine pixelierte Photogeneration von Trägern ist, oder eine Erzeugung von elektrischen Signalen, die geeignet sind, die elektrolumineszente Emission zu bewirken, wenn die erste Funktionalität eine pixelierte elektrolumineszente Emission ist,
- wobei die erste und die zweite planare Struktur durch eine Zusammenfügungsschicht (11) zusammengefügt sind, wobei mindestens eine der planaren Strukturen auf einem starren Substrat (Sub) angeordnet ist,
- wobei das System mindestens einen aktiven Bereich (Zact) umfasst, der zur Implementierung der Funktionalitäten verwendet wird und die Pixelmatrix umfasst, und mindestens einen neutralen Bereich (Zn), der nicht zur Implementierung der Funktionalitäten verwendet wird und am Umfang des aktiven Bereichs angeordnet ist,
- wobei das System ferner Aussparungen (Ev) umfasst, die in mindestens einem neutralen Bereich der planaren Struktur gebildet sind, der nicht auf dem starren Substrat angeordnet ist, der als ausgesparte planare Struktur (Se) bezeichnet wird, wobei der mindestens eine neutrale Bereich, in dem die Aussparungen gebildet sind, am Umfang der Pixelmatrix angeordnet ist und die Aussparungen (Ev) keine elektrische Funktionalität aufweisen.

2. System nach Anspruch 1, wobei eine Tiefe einer Aussparung (pe) derart ist, dass ein Boden der Aussparung in einem Abstand (de) von der Zusammenfügungsschicht von weniger als 1 µm angeordnet ist.

3. System nach einem der Ansprüche 1 oder 2, wobei die Aussparungen die Form von Löchern oder Rillen aufweisen.

4. System nach einem der vorhergehenden Ansprüche, wobei die Aussparungen mit einer Metallschicht bedeckt sind.

5. System nach einem der vorhergehenden Ansprüche, wobei das Material der ausgesparten planaren Struktur (Se) einen höheren Wärmeausdehnungskoeffizienten als der Wärmeausdehnungskoeffizient der anderen planaren Struktur aufweist.

6. System nach einem der vorhergehenden Ansprüche, wobei die ausgesparte planare Struktur eine Dicke von weniger als 20 µm aufweist.

7. System nach einem der vorhergehenden Ansprüche, wobei die Zusammenfügung durch molekulares Kleben hergestellt wird.

8. System nach einem der vorhergehenden Ansprüche, wobei eine Fläche des mindestens einen aktiven Bereichs größer als oder gleich 1 mm² ist.

9. Optoelektronisches Detektionssystem (10) nach einem der vorhergehenden Ansprüche, umfassend eine Pixelmatrix (Matd),
wobei die erste Funktionalität eine pixelierte Photogeneration von Trägern ist, wobei die erste Struktur (S1) eine Vielzahl von Schichten umfasst, darunter eine absorbierende Schicht (AL) aus II-VI oder III-V Halbleitermaterial,
wobei die zweite Funktionalität ein Lesen eines von einem Pixel erzeugten elektrischen Signals ist, wobei die zweite Struktur (S2) eine Leseschaltung (ROIC) umfasst, die eine Vielzahl von vergrabenen Kontakten (TLC) aufweist,
und wobei der mindestens eine aktive Bereich (Zact) die Pixelmatrix umfasst und der mindestens eine neutrale Bereich (Zn) am Umfang der Pixelmatrix angeordnet ist.

10. Optoelektronisches Detektionssystem (10) nach Anspruch 9, wobei die erste Struktur (S1) in mindestens einer Schicht eine Vielzahl von dotierten Bereichen (DZ) umfasst, die so konfiguriert sind, dass sie von der absorbierenden Schicht photogenerierte Träger sammeln, wobei ein dotierter Bereich ein Pixel (Pix) des Detektionssystems definieren kann, wobei das elektrische Signal von einem Pixel aus den von der absorbierenden Schicht (AL) photogenerierten Trägern erzeugt wird, wobei eine elektrische Verbindung zwischen einem dotierten Bereich (DZ) und einem vergrabenen Kontakt (TLC) der Leseschaltung (ROIC) über metallisierte Durchkontaktierungslöcher (IH) hergestellt wird, und wobei die ausgesparte planare Struktur (Se) diejenige ist, die von den Durchkontaktierungslöchern durchquert wird.

11. Optoelektronisches Detektionssystem (10) nach Anspruch 10, wobei die zweite Struktur (S2) auf dem starren Substrat (Sub) angeordnet ist, wobei die Durchkontaktierungslöcher (IH) durch die erste Struktur (S1) und die Leseschaltung (ROIC) bis zum Kontakt (TLC) verlaufen, wobei jeder dotierte Bereich (DZ) sich ringförmig um ein Durchkontaktierungsloch erstreckt, wobei die ausgesparte planare Struktur (Se) die erste planare Struktur (S1) ist.

12. Optoelektronisches Detektionssystem (10) nach einem der Ansprüche 10 oder 11, wobei eine Tiefe einer Aussparung (Pe) derart ist, dass die Aussparung die Leseschaltung nicht erreicht.

13. Optoelektronisches Erfassungssystem (10) nach einem der Ansprüche 9 bis 12, wobei die Aussparungen in dem neutralen Bereich (Zn) ausgeführt sind, der zwischen einem gemeinsamen Kontakt (CC) und Kontaktpads (CP) des Systems angeordnet ist.

14. Optoelektronisches Detektionssystem (10) nach Anspruch 13, wobei eine erste Vielzahl von Aussparungen miteinander verbunden ist, um ein Testpad (TestP) zu bilden, und wobei eine zweite Vielzahl von Aussparungen miteinander und mit dem gemeinsamen Kontakt (CC) der Pixelmatrix (Matd) verbunden ist.

15. Optoelektronisches Detektionssystem nach einem der Ansprüche 9 oder 10, wobei die erste planare Struktur (S1) auf dem starren Substrat (Sub) angeordnet ist, wobei das starre Substrat transparent ist, wobei jeder dotierte Bereich (DZ) in einer Kontaktschicht (CL) gebildet ist, die unterhalb der absorbierenden Schicht (AL) angeordnet ist,
wobei die zweite planare Struktur (S2) auf einem ausgedünnten Substrat (Sub') angeordnet ist,
wobei die Durchkontaktierungslöcher (IH) durch das ausgedünnte Substrat (Sub') und die zweite planare Struktur (S2) verlaufen, wobei die ausgesparte planare Struktur (Se) die zweite planare Struktur (S2) ist, wobei die Aussparungen in dem ausgedünnten Substrat (Sub') und der zweiten planaren Struktur (S2) gebildet sind.

16. Optoelektronisches Anzeigesystem nach einem der Ansprüche 1 bis 8, umfassend eine Matrix aus elektrolumineszenten Pixeln (Matel)
wobei die erste Funktionalität eine pixelierte Emission ist, wobei die erste planare Struktur (S1) eine Vielzahl von Schichten umfasst, einschließlich einer elektrolumineszierenden Schicht,
wobei die zweite Funktionalität eine Erzeugung von elektrischen Signalen ist, die geeignet sind, die Elektrolumineszenzemission zu realisieren, wobei die zweite planare Struktur (S2) eine auf einem Siliziumsubstrat aufgebrachte Pixeladressierungsschaltung (AC) umfasst, und wobei der mindestens eine aktive Bereich (Zact) die Pixelmatrix (Matel) umfasst und der mindestens eine neutrale Bereich (Zn) am Umfang der Pixelmatrix angeordnet ist, wobei die ausgesparte Struktur (Se) der ersten planaren Struktur (S1) entspricht.

17. Elektronisches System nach einem der Ansprüche 1 bis 8, wobei die erste planare Struktur (S1) eine Vielzahl von Transistoren (T) umfasst und die zweite planare Struktur Schaltungen (Circ) umfasst, die den Transistoren zugeordnet sind, und wobei der mindestens eine aktive Bereich (Zact) die Transistoren umfasst und der mindestens eine neutrale Bereich (Zn) am Umfang der Transistoren angeordnet ist, wobei die ausgesparte Struktur (Se) der ersten planaren Struktur (S1) entspricht.

18. System nach einem der Ansprüche 16 oder 17, ferner umfassend Durchkontaktierungslöcher (CV) in dem aktiven Bereich.

19. Verfahren (50) zur Herstellung eines hybriden optischen und/oder elektronischen Systems, wobei das Verfahren die folgenden Schritte umfasst:
- Zusammenfügen (100), durch eine Zusammenfügungsschicht (11), einer ersten planaren Struktur (S1), die eine erste Funktionalität aufweist und eine Pixelmatrix umfasst, die aus mindestens einem ersten Material (M1) hergestellt ist, wobei die erste Funktionalität eine pixelierte Photogeneration von Trägern oder eine pixelierte elektrolumineszente Emission ist, wobei die erste Struktur (S1) auf einem ersten Substrat (Sub1) abgelagert wird, und einer zweiten planaren Struktur (S2), die eine zweite Funktionalität aufweist, die aus mindestens einem zweiten Material (M2) hergestellt ist, das sich von dem ersten Material unterscheidet, wobei die zweite Struktur (S2) auf einem zweiten Substrat (Sub2) abgelagert wird, wobei die zweite Funktionalität ein Lesen eines von einem Pixel erzeugten elektrischen Signals ist, wenn die erste Funktionalität eine pixelierte Photogeneration von Trägern ist, oder eine Erzeugung von elektrischen Signalen, die geeignet sind, die elektrolumineszente Emission zu realisieren, wenn die erste Funktionalität eine pixelierte elektrolumineszente Emission ist,
wobei die erste und die zweite zusammengesetzte Struktur mindestens einen aktiven Bereich (Zact) umfassen, der zur Implementierung der Funktionalitäten verwendet wird, und mindestens einen neutralen Bereich (Zn), der nicht zur Implementierung der Funktionalitäten verwendet wird, wobei der aktive Bereich die Pixelmatrix umfasst,
- Ablösen (200) eines der Substrate, sodass nur ein einziges starres Substrat (Sub1, Sub2) erhalten bleibt,
- Herstellen (300) von Aussparungen (Ev) in mindestens einem neutralen Bereich (Zn) der planaren Struktur, der nicht auf dem starren Substrat angeordnet ist, genannt ausgesparte planare Struktur (Se), wobei der mindestens eine neutrale Bereich, in dem die Aussparungen hergestellt werden, am Umfang der Pixelmatrix angeordnet ist und die Aussparungen keine elektrische Funktionalität haben.

20. Verfahren (50) nach Anspruch 19, ferner umfassend einen Schritt (250) des Ersetzens des verbleibenden Substrats durch ein Zielsubstrat (Subd).

21. Verfahren (50) nach einem der Ansprüche 19 oder 20 zur Herstellung eines hybriden optoelektronischen Detektors, der eine Pixelmatrix (Matd) umfasst,
wobei die erste Funktionalität eine pixelierte Photogeneration von Trägern ist, wobei die erste Struktur (S1) eine Vielzahl von Schichten umfasst, darunter eine absorbierende Schicht (AL) aus II-VI- oder III-V-Halbleitermaterial,
wobei die zweite Funktionalität ein Lesen eines von einem Pixel erzeugten Signals ist, wobei die zweite Struktur (S2) eine Leseschaltung (ROIC) umfasst, die dazu bestimmt ist, ein elektrisches Signal anhand der von der absorbierenden Schicht (AL) photogenerierten Träger abzugreifen, und die eine Vielzahl von vergrabenen Kontakten (TLC) umfasst,
wobei der mindestens eine aktive Bereich (Zact) die Pixelmatrix umfasst, und der mindestens eine neutrale Bereich (Zn) am Umfang der Pixelmatrix angeordnet ist,
wobei der Schritt der Herstellung der Aussparungen (300) darin besteht, gleichzeitig Durchkontaktierungslöcher (IH) in dem mindestens einen aktiven Bereich (Zact) durch eine der planaren Strukturen und die Aussparungen (Ev) in dem mindestens einen neutralen Bereich (Zn) der planaren Struktur, die von den Durchkontaktierungslöchern durchquert wird, zu bilden.

22. Verfahren (50) zur Herstellung nach einem der Ansprüche 19 bis 21 eines hybriden optoelektronischen Detektors, ferner folgende Schritte umfassend:
- Herstellen (400) einer Vielzahl von dotierten Bereichen (DZ), die so konfiguriert sind, dass sie von der absorbierenden Schicht photogenerierte Träger sammeln, wobei ein dotierter Bereich zur Definition eines Pixels (Pix) des Detektors dient,
- elektrisches Verbinden (500) jedes dotierten Bereichs (DZ) mit dem zugeordneten Kontakt (TLC) der Leseschaltung (ROIC) über die Durchkontaktierungslöcher (IH).

23. Verfahren nach einem der Ansprüche 21 bis 22, wobei der Schritt der gleichzeitigen Herstellung der Durchkontaktierungslöcher und der Aussparungen durch Ätzen der ersten planaren Struktur (S1) und, für die Durchkontaktierungslöcher, der Leseschaltung (ROIC) bis zu den vergrabenen Kontakten (TLC) erfolgt, wobei die ausgesparte planare Struktur der ersten planaren Struktur entspricht.

24. Verfahren nach einem der Ansprüche 21 bis 22, wobei der Schritt der gleichzeitigen Herstellung der Durchkontaktierungslöcher und der Aussparungen durch Ätzen des ausgedünnten Substrats (Sub'), auf dem die Leseschaltung abgelagert ist, und mindestens teilweise der Leseschaltung (ROIC) erfolgt, wobei die ausgesparte planare Struktur der zweiten Struktur entspricht.

25. Verfahren nach einem der Ansprüche 21 bis 24, wobei der Schritt der gleichzeitigen Herstellung der Durchkontaktierungslöcher (IH) und der Aussparungen (Ev) durch Lithografie und anschließendes Ätzen erfolgt, wobei die Lithografietechnologie ausgewählt ist aus: Elektronenstrahl; Nanoprint; optischer Lithografie, und die Ätztechnologie ausgewählt ist aus Ionenätzen, chemischem Ätzen oder Plasmaätzen.

## Claims

1. A hybrid optical and/or electronic system (10) comprising a matrix of pixels (Matd, Matel) and comprising:
- a first planar structure (S1) having a first functionality produced in at least one first material (M1), wherein the first functionality is a pixelised photogeneration of carriers or a pixelised light emission,
- a second planar structure (S2) having a second functionality produced in at least one second material (M2) that is different from the first material, wherein the second functionality is a read-out of an electrical signal generated by a pixel, when the first functionality is a pixelised photogeneration of carriers or a generation of electrical signals suitable for producing said light emission, when the first functionality is a pixelised light emission,
- the first and second planar structures being assembled by an assembly layer (11), at least one of the planar structures being disposed on a rigid substrate (Sub),
- the system comprising at least one active zone (Zact) used to implement said functionalities and comprising said matrix of pixels and at least one neutral zone (Zn) not used to implement said functionalities and disposed at the periphery of said active zone,
- the system further comprising recesses (Ev) produced in at least one neutral zone of the planar structure which is not disposed on the rigid substrate, called recessed planar structure (Se), said at least one neutral zone, in which the recesses are produced, being located at the periphery of said matrix of pixels and the recesses (Ev) not having any electrical functionality.

2. The system according to claim 1, wherein a depth of a recess (pe) is such that a bottom of said recess is disposed at a distance (de) from the assembly layer that is less than 1 µm.

3. The system according to one of claims 1 or 2, wherein the recesses take the form of holes or of furrows.

4. The system according to one of the preceding claims, wherein the recesses are covered with a metallic layer.

5. The system according to one of the preceding claims, wherein the material of the recessed planar structure (Se) has a thermal expansion coefficient greater than the thermal expansion coefficient of the other planar structure.

6. The system according to one of the preceding claims, wherein the recessed planar structure has a thickness less than 20 µm.

7. The system according to one of the preceding claims, wherein the assembly is produced by molecular bonding.

8. The system according to one of the preceding claims, wherein a surface area of the at least one active zone is greater than or equal to 1 mm².

9. An optoelectronic detection system (10) according to one of the preceding claims, comprising a matrix of pixels (Matd),
wherein the first functionality is a pixelised photogeneration of carriers, the first structure (S1) comprising a plurality of layers including an absorbent layer (AL) made of II-VI or III-V semiconductor material,
wherein the second functionality is a read-out of an electrical signal generated by a pixel, the second structure (S2) comprising a read-out circuit (ROIC) comprising a plurality of buried contacts (TLC),
and wherein the at least one active zone (Zact) comprises said matrix of pixels and the at least one neutral zone (Zn) is disposed at the periphery of said matrix of pixels.

10. The optoelectronic detection system (10) according to claim 9, wherein the first structure (S1) comprises, in at least one layer, a plurality of doped zones (DZ) configured to collect carriers photogenerated by the absorbent layer, a doped zone making it possible to define a pixel (Pix) of the detection system, wherein the electrical signal is generated by a pixel from said carriers photogenerated by the absorbent layer (AL), an electrical connection between a doped zone (DZ) and a buried contact (TLC) of the read-out circuit (ROIC) being produced by metallised interconnection holes (IH), and wherein the recessed planar structure (Se) is that which is passed through by the interconnection holes.

11. The optoelectronic detection system (10) according to claim 10, wherein the second structure (S2) is disposed on the rigid substrate (Sub), wherein the interconnection holes (IH) pass through the first structure (S1) and the read-out circuit (ROIC) to the contact (TLC), wherein each doped zone (DZ) extends annularly round an interconnection hole, the recessed planar structure (Se) being the first planar structure (S1).

12. The optoelectronic detection system (10) according to one of claims 10 or 11, wherein a depth of a recess (Pe) is such that said recess does not reach the read-out circuit.

13. The optoelectronic detection system (10) according to one of claims 9 to 12, wherein the recesses are produced in the neutral zone (Zn) disposed between a common contact (CC) and contact pads (CP) of said system.

14. The optoelectronic detection system (10) according to claim 13, wherein a first plurality of recesses are interconnected with one another so as to form a test pad (TestP) and wherein a second plurality of recesses are linked to one another and to said common contact (CC) of the matrix of pixels (Matd).

15. The optoelectronic detection system according to one of claims 9 or 10, wherein the first planar structure (S1) is disposed on the rigid substrate (Sub), said rigid substrate being transparent, wherein each doped zone (DZ) is produced in a contact layer (CL) disposed under the absorbent layer (AL),
wherein the second planar structure (S2) is disposed on a thinner substrate (Sub'),
wherein the interconnection holes (IH) pass through the thinner substrate (Sub') and the second planar structure (S2), the recessed planar structure (Se) being the second planar structure (S2), the recesses being produced in the thinner substrate (Sub') and the second planar structure (S2).

16. An optoelectronic display system according to one of claims 1 to 8, comprising a matrix of light-emitting pixels (Matel),
wherein the first functionality is a pixelised emission, the first planar structure (S1) comprising a plurality of layers including a light-emitting layer,
wherein the second functionality is a generation of electrical signals suitable for producing the light emission, the second planar structure (S2) comprising an addressing circuit (AC) for the pixels which is deposited on a silicon substrate, and wherein the at least one active zone (Zact) comprises said matrix of pixels (Matel) and the at least one neutral zone (Zn) is disposed at the periphery of said matrix of pixels, the recessed structure (Se) corresponding to the first planar structure (S1).

17. An electronic system according to one of claims 1 to 8, wherein the first planar structure (S1) comprises a plurality of transistors (T) and the second planar structure comprises circuits (Circ) associated with said transistors, and wherein the at least one active zone (Zact) comprises said transistors and the at least one neutral zone (Zn) is disposed at the periphery of said transistors, the recessed structure (Se) corresponding to the first planar structure (S1).

18. The system according to one of claims 16 or 17, further comprising interconnection vias (CV) in the active zone.

19. A method (50) for fabricating a hybrid optical and/or hybrid electronic system, the method comprising the steps of:
- assembling (100), by an assembly layer (11), a first planar structure (S1) having a first functionality and comprising a matrix of pixels produced in at least one first material (M1), said first functionality being a pixelised photogeneration of carriers or a pixelised light emission, the first structure (S1) being deposited on a first substrate (Sub1), and a second planar structure (S2) having a second functionality produced in at least one second material (M2) that is different from the first material, the second structure (S2) being deposited on a second substrate (Sub2), said second functionality being a read-out of an electrical signal generated by a pixel, when the first functionality is a pixelised photogeneration of carriers or a generation of electrical signals suitable for producing said light emission, when the first functionality is a pixelised light emission,
the first and second assembled structures comprising at least one active zone (Zact) used to implement said functionalities, and at least one neutral zone (Zn) not used to implement said functionalities, said active zone comprising the matrix of pixels,
- detaching (200) one of the substrates so as to retain only a single rigid substrate (Sub1, Sub2),
- producing (300) recesses (Ev) in at least one neutral zone (Zn) of the planar structure which is not disposed on the rigid substrate, called recessed planar structure (Se), said at least one neutral zone, in which the recesses are produced, being located at the periphery of said matrix of pixels and the recesses not having any electrical functionality.

20. The method (50) according to claim 19, further comprising a step (250) of replacement of the remaining substrate with a destination substrate (Subd).

21. The fabrication method (50) according to one of claims 19 or 20 for fabricating a hybrid optoelectronic detector comprising a matrix of pixels (Matd),
the first functionality being a pixelised photogeneration of carriers, the first structure (S1) comprising a plurality of layers including an absorbent layer (AL) made of II-VI or III-V semiconductor material,
the second functionality being a read-out of a signal generated by a pixel, the second structure (S2) comprising a read-out circuit (ROIC) intended to recover an electrical signal from said carriers photogenerated by the absorbent layer (AL) and comprising a plurality of buried contacts (TLC),
the at least one active zone (Zact) comprising the matrix of pixels, and the at least one neutral zone (Zn) being disposed at the periphery of said matrix of pixels,
the step of production of the recesses (300) consisting in simultaneously producing interconnection holes (IH) in the at least one active zone (Zact) through one of the planar structures, and said recesses (Ev) in the at least one neutral zone (Zn) of said planar structure passed through by the interconnection holes.

22. The fabrication method (50) according to one of claims 19 to 21 for fabricating a hybrid optoelectronic detector, further comprising the steps of:
- producing (400) a plurality of doped zones (DZ) configured to collect carriers photogenerated by the absorbent layer, a doped zone making it possible to define a pixel (Pix) of the detector,
- electrically connecting (500) each doped zone (DZ) with the associated contact (TLC) of the read-out circuit (ROIC) via the interconnection holes (IH).

23. The method according to one of claims 21 to 22, wherein the step of simultaneous production of the interconnection holes and of the recesses is performed by etching of the first planar structure (S1) and, for the interconnection holes, of the read-out circuit (ROIC) to the buried contacts (TLC), the recessed planar structure corresponding to the first planar structure.

24. The method according to one of claims 21 to 22, wherein the step of simultaneous production of the interconnection holes and of the recesses is performed by etching of the thinner substrate (Sub') on which the read-out circuit is deposited and at least partially of the read-out circuit (ROIC), the recessed planar structure corresponding to the second structure.

25. The method according to one of claims 21 to 24, wherein the step of simultaneous production of the interconnection holes (IH) and of the recesses (Ev) is performed by lithography then etching, the lithography technology being chosen from among: electron beam; nano-printing; optical lithography, and the etching technology being chosen from among ion etching, chemical or plasma etching.
